# EUROPEAN PATENT APPLICATION

(11) **EP 4 815 656 A1**
(43) Date of publication of application: **30.09.2026**
(21) Application number: 24913450.3
(22) Date of filing: 21.11.2024
(51) Int. Cl.: H05K 9/00, H04M 1/02, G02F 1/1333

(54) **ELECTRONIC DEVICE COMPRISING GROUND STRUCTURE OF CONDUCTIVE LAYER**

(30) Priority: 26.12.2023 KR 20230191976; 16.01.2024 KR 20240007070; 04.03.2024 KR 20240030947
(71) Applicant: Samsung Electronics Co., Ltd., Suwon-si, Gyeonggi-do 16677 (KR)
(72) Inventor: KIM, Hyunsoo, Suwon-si Gyeonggi-do 16677 (KR); LEE, Jongwon, Suwon-si Gyeonggi-do 16677 (KR); KIM, Sangjun, Suwon-si Gyeonggi-do 16677 (KR); KIM, Sujung, Suwon-si Gyeonggi-do 16677 (KR); BAE, Hankook, Suwon-si Gyeonggi-do 16677 (KR); CHUNG, Myungkyoon, Suwon-si Gyeonggi-do 16677 (KR); CHOI, Taekkyun, Suwon-si Gyeonggi-do 16677 (KR)
(74) Representative: Gulde & Partner
(86) International application number: PCT/KR2024/018519
(87) International publication number: WO 2025/143557

(57) **Abstract**

This electronic device may comprise: a bracket; printed circuit board; integrated circuitry (IC) electrically connected to at least another component of the electronic device through the printed circuit board; a shield member which is disposed on the IC and the printed circuit board, and which includes a conductive layer for shielding the IC from electromagnetic interference (EMI); a first conductive gasket, which is disposed between the conductive layer and the printed circuit board, is in contact with a part of the conductive layer and electrically connects the conductive layer to a ground of the printed circuit board; and a second conductive gasket which is disposed between the conductive layer and the bracket, and which is at least partially disposed on the part of the conductive layer in contact with the first conductive gasket.

## Description

### [Technical Field]

The following descriptions relate to an electronic device including the electronic device including a ground structure of a conductive layer.

### [Background Art]

An electronic device may include a display and display driving integrated circuitry (DDIC) for driving a plurality of pixels included in the display. In addition, the electronic device may include a conductive layer covering the DDIC to prevent noise caused by the DDIC from being induced into another configuration, such as an antenna radiator of the electronic device.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

An electronic device according to an embodiment may include a bracket, a printed circuit board, integrated circuitry (IC) electrically connected through the printed circuit board to at least another component of the electronic device, a shielding member, disposed on the IC and the printed circuit board, and including a conductive layer configured to shield electromagnetic interference (EMI) from and/or to the IC, a first conductive gasket, disposed between the conductive layer and the printed circuit board, contacted with a portion of the conductive layer, and electrically connecting the conductive layer to a ground of the printed circuit board, and a second conductive gasket, disposed between the conductive layer and the bracket, at least partially disposed on the portion of the conductive layer contacted with the first conductive gasket.

An electronic device according to an embodiment may include a bracket, a display, a shielding member, a first conductive gasket, and a second conductive gasket. The display may include a display panel, display driving integrated circuitry (DDIC), and a flexible printed circuit board. The display panel may include a flexible substrate including a portion under the bracket. The DDIC may be mounted on the portion of the flexible substrate, positioned between the bracket and the portion of the flexible substrate, and electrically connected to the display panel. The flexible printed circuit board may be disposed between the flexible substrate and the bracket and may be coupled to the portion of the flexible substrate. The shielding member may be disposed on the DDIC and the flexible printed circuit board and may be spaced apart from the bracket. The shielding member may include a conductive layer configured to shield electromagnetic interference (EMI) from and/or to the DDIC. The first conductive gasket may be disposed between the flexible printed circuit board and the conductive layer, may be in contact with a portion of the conductive layer, and may electrically connect the conductive layer to a ground of the flexible printed circuit board. The second conductive gasket may be disposed between the conductive layer and the bracket, and may be at least partially disposed on the portion of the conductive layer contacted with the first conductive gasket. An electronic device according to an embodiment may include a bracket, a printed circuit board, integrated circuitry (IC), a shielding member, a first conductive gasket, and a second conductive gasket. The IC may be electrically connected to at least another component of the electronic device through the printed circuit board. The shielding member may include a conductive layer disposed on the IC and the printed circuit board and configured to shield electromagnetic interference (EMI) from and/or to the IC. The first conductive gasket may be disposed between the conductive layer and the printed circuit board, may be in contact with a portion of the conductive layer, and may electrically connect the conductive layer to a ground of the printed circuit board. The second conductive gasket may be disposed between the conductive layer and the bracket, and may be at least partially disposed on the portion of the conductive layer contacted with the first conductive gasket.

### [Description of the Drawings]

FIG. 1 is a block diagram of an electronic device in a network environment according to various embodiments.
FIG. 2A is a diagram illustrating an exemplary electronic device according to an embodiment.
FIG. 2B is an exploded perspective view of an exemplary electronic device according to an embodiment.
FIG. 3 is an exemplary cross-sectional view of an electronic device according to an embodiment.
FIG. 4 is an exemplary cross-sectional view of an electronic device according to an embodiment.
FIG. 5 is an exemplary cross-sectional view of an electronic device according to an embodiment.
FIG. 6 is an exemplary cross-sectional view of an electronic device according to an embodiment.
FIG. 7 is an exemplary cross-sectional view of an electronic device according to an embodiment.
FIG. 8 is an exemplary cross-sectional view of an electronic device according to an embodiment.
FIG. 9 is an exemplary diagram for describing a flow of a noise signal of an electronic device according to an embodiment.
FIG. 10 is an exemplary diagram illustrating an electronic device according to an embodiment.
FIG. 11 is an exemplary diagram illustrating an electronic device according to an embodiment.
FIG. 12 is an exemplary diagram illustrating an electronic device according to an embodiment.
FIG. 13 is an exemplary diagram illustrating an electronic device according to an embodiment.

### [Mode for Invention]

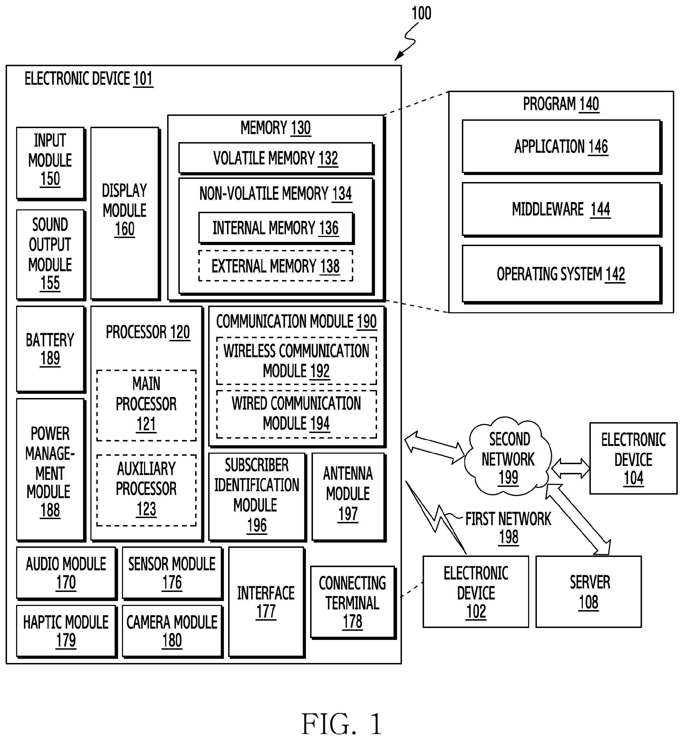

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of lms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

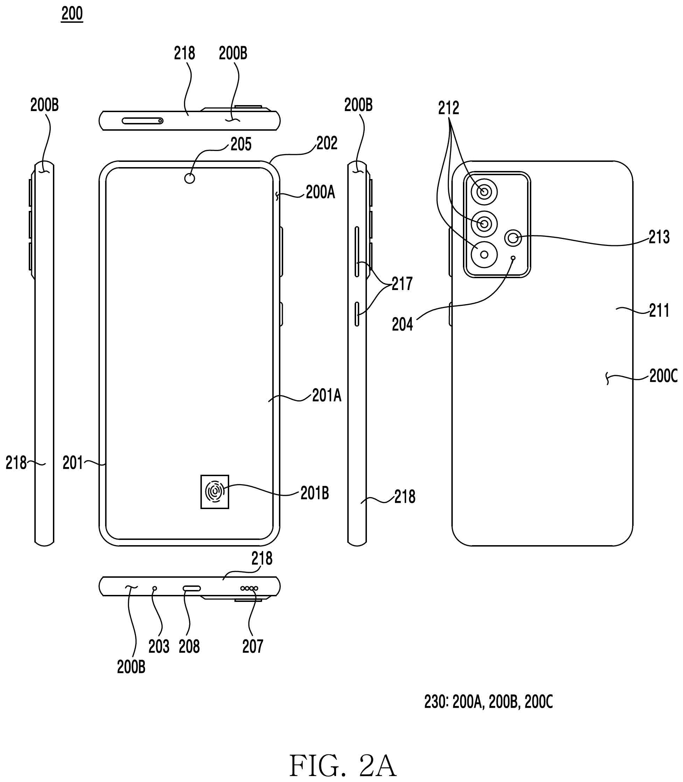

FIG. 2A is a diagram illustrating an exemplary electronic device according to an embodiment. Referring to FIG. 2A, an electronic device 200 according to an embodiment may include a housing 210 forming an exterior of the electronic device 200. For example, the housing 210 may include a first surface (or front surface) 200A, a second surface (or rear surface) 200B, and a third surface (or side surface) 200C surrounding a space between the first surface 200A and the second surface 200B. In an embodiment, the housing 210 may refer to a structure forming at least a portion of the first surface 200A, the second surface 200B, and/or the third surface 200C.

The electronic device 200 according to an embodiment may include a substantially transparent front plate 202. In an embodiment, the front plate 202 may form at least a portion of the first surface 200A. In an embodiment, the front plate 202 may include, for example, a glass plate or a polymer plate including various coating layers, but is not limited thereto.

The electronic device 200 according to an embodiment may include a substantially opaque rear plate 211. In an embodiment, the rear plate 211 may form at least a portion of the second surface 200B. In an embodiment, the rear plate 211 may be formed by coated or colored glass, ceramic, polymer, metal (e.g., aluminum, stainless steel (STS), or magnesium), or a combination of at least two of the materials.

The electronic device 200 according to an embodiment may include a side bezel structure (e.g., a side member or a bracket) 218. In an embodiment, the side bezel structure 218 may form at least a portion of the third surface 200C of the electronic device 200 by being coupled with the front plate 202 and/or the rear plate 211. For example, the side bezel structure 218 may form the entire third surface 200C of the electronic device 200, and for another example, the side bezel structure 218 may form the third surface 200C of the electronic device 200 together with the front plate 202 and/or the rear plate 211.

Unlike the illustrated embodiment, in a case that the third surface 200C of the electronic device 200 is partially formed by the front plate 202 and/or the rear plate 211, the front plate 202 and/or the rear plate 211 may include, from a periphery thereof, a portion that is bent toward the rear plate 211 and/or the front plate 202 and extended. For example, the extended portion of the front plate 202 and/or the rear plate 211 may be positioned at both ends of a long edge of the electronic device 200, but is not limited by the above-described example.

In an embodiment, the side bezel structure 218 may include metal and/or polymer. In an embodiment, the rear plate 211 and the side bezel structure 218 may be integrally formed and may include the same material (e.g., a metallic material such as aluminum), but are not limited thereto. For example, the rear plate 211 and the side bezel structure 218 may be formed in separate configurations and/or may include different materials.

In an embodiment, the electronic device 200 may include a display 201 (e.g., the display module 160 of FIG. 1), an audio module 203, 204, or 207 (e.g., the audio module 170 of FIG. 1), a sensor module (e.g., the sensor module 176 of FIG. 1), a camera module 205, 212, or 213 (e.g., the camera module 180 of FIG. 1), a key input device 217 (e.g., the input module 150 of FIG. 1), a light emitting element (not illustrated), and a connector hole 208. In an embodiment, the electronic device 200 may omit at least one of the components (e.g., the key input device 217 or the light emitting element (not illustrated)), or may additionally include another component.

In an embodiment, the display 201 may be visually exposed through a significant portion of the front plate 202. For example, at least a portion of the display 201 may be visible through the front plate 202 forming the first surface 200A. The display 201 may be disposed on a back surface of the front plate 202.

In an embodiment, in order to expand an area in which the display 201 is visually exposed, an outer shape of the display 201 may be formed substantially the same as an outer shape of the front plate 202 adjacent to the display 201. In an embodiment, a distance between an outer periphery of the display 201 and an outer periphery of the front plate 202 may be formed substantially the same.

In an embodiment, the display 201 (or the first surface 200A of the electronic device 200) may include a screen display region 201A. In an embodiment, the display 201 may provide a user with visual information through the screen display region 201A. In the illustrated embodiment, when the first surface 200A is viewed from the front, the screen display region 201A is illustrated as being spaced apart from an outer periphery of the first surface 200A and positioned inside the first surface 200A, but is not limited thereto. For example, when the first surface 200A is viewed from the front, at least a portion of a periphery of the screen display region 201A may substantially coincide with a periphery of the first surface 200A (or the front plate 202).

In an embodiment, the screen display region 201A may include a sensing region 201B configured to obtain biometric information of the user. Herein, a meaning of "the screen display region 201A including the sensing region 201B" may be understood as that at least a portion of the sensing region 201B may be overlapped with the screen display region 201A. For example, the sensing region 201B may mean a region in which visual information may be displayed by the display 201 like another region of the screen display region 201A, and additionally obtain biometric information (e.g., a fingerprint) of the user. Although the sensing region 201B is illustrated as being formed in the screen display region 201A, it is not limited thereto. For example, the sensing region 201B may be formed in the key input device 217.

In an embodiment, the display 201 may include a region in which the first camera module 205 is positioned. For example, an opening portion may be formed in the region of the display 201, and the first camera module 205 (e.g., a punch hole camera) may be at least partially disposed in the opening portion to face the first surface 200A. In this case, the screen display region 201A may surround at least a portion of a periphery of the opening portion. In an embodiment, the first camera module 205 (e.g., an under display camera (UDC)) may be disposed under the display 201 to overlap the region of the display 201. In this case, the display 201 may provide the user with visual information through the region, and additionally, the first camera module 205 may obtain an image corresponding to a direction toward the first surface 200A through the region of the display 201.

In an embodiment, the display 201 may be coupled with or disposed adjacent to touch sensing circuitry, a pressure sensor capable of measuring an intensity (pressure) of a touch, and/or a digitizer that detects a magnetic field type stylus pen.

In an embodiment, the audio module 203, 204, or 207 may include a microphone hole 203 or 204 and a speaker hole 207.

In an embodiment, the microphone hole 203 or 204 may include a first microphone hole 203 formed in a partial region of the third surface 200C and a second microphone hole 204 formed in a partial region of the second surface 200B. A microphone (not illustrated) for obtaining external sound may be disposed inside the microphone hole 203 or 204. The microphone may include a plurality of microphones to sense a direction of sound, but is not limited thereto.

In an embodiment, the second microphone hole 204 formed in a partial region of the second surface 200B may be disposed adjacent to the camera module 205, 212, or 213. For example, the second microphone hole 204 may obtain a sound according to an operation of the camera module 205, 212, or 213. However, it is not limited thereto.

In an embodiment, the speaker hole 207 may include an external speaker hole 207 and a call receiver hole (not illustrated). The external speaker hole 207 may be formed in a portion of the third surface 200C of the electronic device 200. In an embodiment, the external speaker hole 207 may be integrated into the microphone hole 203, and the speaker hole 207 and the microphone hole 203 may be implemented as one hole. Although not illustrated, the call receiver hole (not illustrated) may be formed in another portion of the third surface 200C. For example, the call receiver hole may be formed in an opposite side of the external speaker hole 207 on the third surface 200C. For example, with respect to the illustration of FIG. 2A, the external speaker hole 207 may be formed on the third surface 200C corresponding to a lower end portion of the electronic device 200, and the call receiver hole may be formed on the third surface 200C corresponding to an upper end portion of the electronic device 200. However, it is not limited thereto, and in another embodiment, the call receiver hole may be formed at a position other than the third surface 200C. For example, the call receiver hole may be formed by a separated space between the front plate 202 (or the display 201) and the side bezel structure 218.

In an embodiment, the electronic device 200 may include at least one speaker (not illustrated) (e.g., the sound output module 155 of FIG. 1) configured to output sound to the outside of the housing 210 through the external speaker hole 207 and/or the call receiver hole (not illustrated).

In an embodiment, the sensor module (not illustrated) may generate an electrical signal or a data value corresponding to an operating state of an inside of the electronic device 200 or an environmental state of an outside. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera module 205, 212, or 213 may include the first camera module 205 disposed to face the first surface 200A of the electronic device 200, a second camera module 212 disposed to face the second surface 200B, and a flash 213.

In an embodiment, the second camera module 212 may include a plurality of cameras (e.g., a dual camera, a triple camera, or a quad camera). However, the second camera module 212 is not necessarily limited to including the plurality of cameras, and may include one camera.

In an embodiment, the first camera module 205 and the second camera module 212 may include one or a plurality of lenses, an image sensor, and/or an image signal processor.

In an embodiment, the flash 213 may include, for example, a light emitting diode or a xenon lamp. In an embodiment, two or more lenses (an infrared camera, a wide-angle and telephoto lens) and image sensors may be disposed on a surface of the electronic device 200.

In an embodiment, the key input device 217 may be disposed on the third surface 200C of the electronic device 200. In an embodiment, the electronic device 200 may not include some or all of the key input device 217, and the key input device 217, which is not included, may be implemented in another form, such as a soft key, on the display 201.

In an embodiment, the connector hole 208 may be formed on the third surface 200C of the electronic device 200 to accommodate a connector of an external device. A connecting terminal (e.g., the connecting terminal 178 of FIG. 1) electrically connected to a connector of an external device may be disposed in the connector hole 208. The electronic device 200 according to an embodiment may include an interface module (e.g., the interface 177 of FIG. 1) for processing an electrical signal transmitted and received through the connecting terminal.

In an embodiment, the electronic device 200 may include a light emitting element (not illustrated). For example, the light emitting element (not illustrated) may be disposed on the first surface 200A of the housing 210. The light emitting element (not illustrated) may provide state information of the electronic device 200 in an optical form. In an embodiment, the light emitting element (not illustrated) may provide a light source linked with an operation of the first camera module 205. For example, the light emitting element (not illustrated) may include an LED, an IR LED, and/or a xenon lamp.

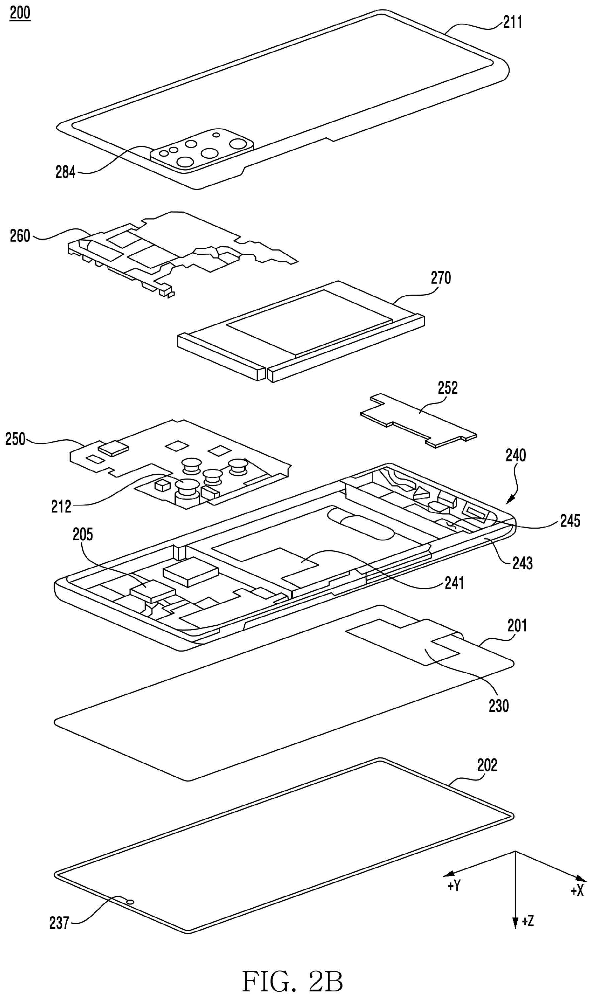

FIG. 2B is an exploded perspective view of an exemplary electronic device according to an embodiment. Referring to FIG. 2B, the electronic device 200 according to an embodiment may include a frame structure 240 (e.g., the side bezel structure 218 of FIG. 2A), a first printed circuit board 250, a second printed circuit board 252, a cover plate 260, and a battery 270 (e.g., the battery 189 of FIG. 1).

In an embodiment, the frame structure 240 may be positioned between the display 201 and the rear plate 211. In an embodiment, the frame structure 240 may support or accommodate components included in the electronic device 200. For example, the display 201 may be disposed on a surface of the frame structure 240 facing in a direction (e.g., a +Z direction). The first printed circuit board 250, the second printed circuit board 252, the battery 270, and the second camera module 212 may be disposed on another surface of the frame structure 240 facing an opposite direction (e.g., in a -Z direction) to the direction. The first printed circuit board 250, the second printed circuit board 252, the battery 270, and the second camera module 212 may be disposed in a recess formed in the frame structure 240.

In an embodiment, the frame structure 240 may include a first part 241 and a second part 243 surrounding the first part 241. The first part 241 may support the display 201 by being positioned under the display 201 (e.g., in the -Z direction). Alternatively, the first part 241 may support the display 201 together with the second part 243. The second part 243 may surround a space between the rear plate 211 and the front plate 202 (and/or the display 201). The second part 243 surrounding the space may form a side surface (e.g., the third surface 200C of FIG. 2A) of the electronic device 200, and the first part 241 positioned in the space may extend inward from the second part 243. The side surface may extend from a circumference of a front surface (e.g., the first surface 200A of FIG. 2A) or the front plate 202 of the electronic device 200. In an embodiment, the first part 241 and the second part 243 may be formed of metal and/or polymer. For example, the first part 241 and the second part 243 may include a conductive part formed of a conductive material such as the metal and/or a non-conductive part formed of the polymer. A surface of the conductive part may include a first region in which an oxide layer (or oxide film) of the conductive material is formed to prevent corrosion and a second region (e.g., by removing the oxide film) in which the conductive material is opened (or exposed). A conductive gasket (e.g., conductive gaskets 410, 710, 810, and 1310) to be described later may be electrically connected to the second region of the conductive part. In an embodiment, the conductive portion of the second part 243 may be used as an antenna radiator for transmitting and receiving a wireless signal.

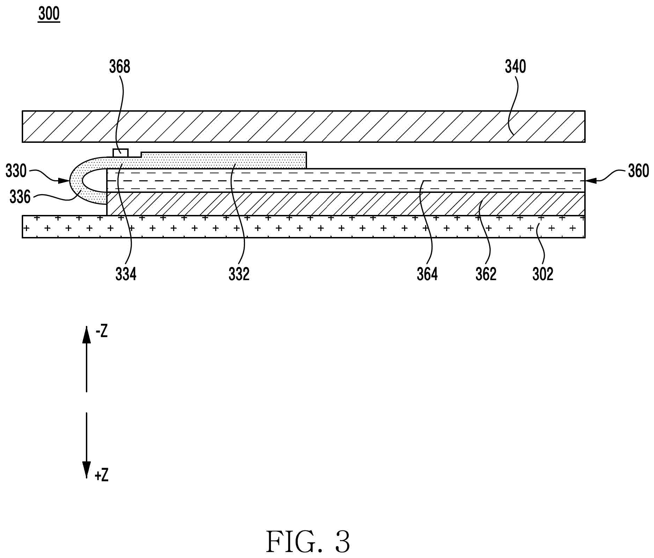

In an embodiment, the frame structure 240 or the first part 241 of the frame structure 240 may be referred to as a support member. The frame structure 240 may be referred to as a bracket or a support bracket (e.g., the support bracket 340 of FIG. 3). The first part 241 of the frame structure 240 may be referred to as a support or a support portion of the frame structure 240. The second part 243 of the frame structure 240 may be referred to as a sidewall or a sidewall portion of the frame structure 240.

In an embodiment, the first printed circuit board 250, the second printed circuit board 252, and the battery 270 may be coupled with the frame structure 240, respectively. For example, the first printed circuit board 250 and the second printed circuit board 252 may be fixedly disposed in the frame structure 240 through a coupling member such as a screw. For example, the battery 270 may be fixedly disposed in the frame structure 240 through an adhesive member (e.g., a double-sided tape). However, it is not limited by the above-described example.

In an embodiment, the display 201 may be disposed between the frame structure 240 and the front plate 202. For example, the front plate 202 may be disposed on a side (e.g., in the +Z direction) of the display 201, and the frame structure 240 may be disposed on another side (e.g., in the -Z direction).

In an embodiment, the front plate 202 may be coupled with the display 201. For example, the display 201 may be attached to the back surface of the front plate 202 through an optical adhesive member (e.g., an optically clear adhesive (OCA) or an optically clear resin (OCR)).

In an embodiment, the front plate 202 may be coupled with the frame structure 240. For example, the front plate 202 may include, when viewed in a z-axis direction, an outer portion extending outside the display 201. The frame structure 240 (e.g., the second part 243) may be attached to the outer portion, but is not limited thereto.

In an embodiment, a processor (e.g., the processor 120 of FIG. 1), memory (e.g., the memory 130 of FIG. 1), and/or an interface (e.g., the interface 177 of FIG. 1) may be disposed on the first printed circuit board 250 and/or the second printed circuit board 252. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. In an embodiment, the first printed circuit board 250 and the second printed circuit board 252 may be operatively or electrically connected to each other through a connection member (e.g., a flexible printed circuit board).

In an embodiment, the cover plate 260 may be disposed between the first printed circuit board 250 and the rear plate 211. In an embodiment, the cover plate 260 may be disposed on the first printed circuit board 250. For example, the cover plate 260 may be disposed on a surface of the first printed circuit board 250 facing the -Z direction.

In an embodiment, the cover plate 260 may at least partially overlap the first printed circuit board 250 with respect to a z-axis. In an embodiment, the cover plate 260 may cover at least a partial region of the first printed circuit board 250. Through this, the cover plate 260 may protect the first printed circuit board 250 from a physical impact or prevent detachment of the connector coupled to the first printed circuit board 250.

In an embodiment, the cover plate 260 may be fixedly disposed on the first printed circuit board 250 through a coupling member (e.g., a screw), or may be coupled to the frame structure 240 together with the first printed circuit board 250 through the coupling member.

In an embodiment, the cover plate 260 may include a conductive portion. Additionally, the cover plate 260 may include a non-conductive portion. The conductive portion of the cover plate 260 may be formed of a conductive metal such as stainless steel, and the non-conductive portion may be formed of a non-conductive material such as plastic.

In an embodiment, the battery 270 may supply power to at least one component of the electronic device 200. For example, the battery 270 may include a rechargeable secondary battery or a fuel cell.

In an embodiment, the first camera module 205 (e.g., a front camera) may be disposed in at least a portion of the frame structure 240 (e.g., the first part 241) such that a lens may receive external light through a partial region (e.g., a camera region 237) of the front plate 202 (e.g., the front surface 200A of FIG. 2A).

In an embodiment, the second camera module 212 (e.g., a rear camera) may be disposed between the frame structure 240 and the rear plate 211. In an embodiment, the second camera module 212 may be electrically connected to the first printed circuit board 250 through a connection member (e.g., a connector). In an embodiment, the second camera module 212 may be disposed such that a lens may receive external light through a camera region 284 of the rear plate 211 of the electronic device 200.

In an embodiment, the camera region 284 may be formed on a surface (e.g., the rear surface 200B of FIG. 2A) of the rear plate 211. In an embodiment, the camera region 284 may be formed to be at least partially transparent such that external light may be incident on the lens of the second camera module 212. In an embodiment, at least a portion of the camera region 284 may protrude from the surface of the rear plate 211 to a predetermined height. However, it is not limited thereto, and in another embodiment, the camera region 284 may form substantially the same plane as the surface of the rear plate 211.

In an embodiment, the housing 210 of the electronic device 200 may mean a configuration or a structure forming at least a portion of the exterior of the electronic device 200. In this regard, at least a portion of the front plate 202, the frame structure 240, and/or the rear plate 211 forming the exterior of the electronic device 200 may be referred to as the housing 210 of the electronic device 200.

In an embodiment, the electronic device 200 (or the display 201) may include a flexible printed circuit board 230. The flexible printed circuit board 230 may extend from a panel (or a substrate of the panel) of the display 201. For example, the flexible printed circuit board 230 may be bent and extended from the panel of the display 201 so as to be stacked on the display 201. The flexible printed circuit board 230 may electrically connect the display 201 and a printed circuit board (e.g., the first printed circuit board 250 or the second printed circuit board 252) of the electronic device 200. For example, the flexible printed circuit board 230 may be connected to the first printed circuit board 250 through another flexible printed circuit board extending from the first printed circuit board 250, passing through an opening 245, to the flexible printed circuit board 230. For another example, the flexible printed circuit board 230 may face the second printed circuit board 252 through the opening 245 formed in the second part 243 of the frame structure 240. A connector of the flexible printed circuit board 230 and a corresponding connector of the second printed circuit board 252 may be connected through the opening 245. Signals for driving the display 201 may be transmitted through the flexible printed circuit board 230.

The electronic device 200 according to an embodiment may include an antenna module (not illustrated). In an embodiment, the antenna module may be disposed between the rear plate 211 and the cover plate 260. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power to and from an external device.

In the present disclosure, description of a configuration having the same reference numeral may be applied in the same or corresponding manner unless otherwise specified, even with reference to different drawings. In addition, overlapping description for the configuration having the same reference numeral may be omitted.

In the present disclosure, "overlapping" only means that at least a portion of a component is positioned within a boundary of another component when projected at a point of view, and it is not interpreted that they are physically contacted or separated unless otherwise specified.

FIG. 3 is an exemplary cross-sectional view of an electronic device according to an embodiment.

An electronic device 300 of FIG. 3 may be an example of the electronic device 101 of FIG. 1 or the electronic device 200 of FIGS. 2A and 2B. Referring to FIG. 3, the electronic device 300 according to an embodiment may include a window 302, a display 360, display driving circuitry 368, a flexible printed circuit board 330, and a support bracket 340. The window 302 may be an example of the front plate 202 of FIGS. 2A and 2B. The display 360 may be an example of the display module 160 of FIG. 1 or the display 201 of FIGS. 2A and 2B. The flexible printed circuit board 330 may be an example of the flexible printed circuit board 230 of FIG. 2B. The support bracket 340 may be an example of the side bezel structure 218 of FIG. 2A or the frame structure 240 of FIG. 2B.

In an embodiment, the window 302 may be disposed under the display 360 (e.g., in a +Z direction). The window 302 may be disposed on a front surface of the display 360. For example, the window 302 may be attached to the front surface of the display 360. For example, the window 302 may be attached to the display 360 through an optical adhesive member such as an optically clear adhesive (OCA) or an optically clear resin (OCR). In an embodiment, the window 302 may protect the display 360 from an external impact, and may transmit light output from the display 360 to the outside by allowing the light to penetrate therethrough.

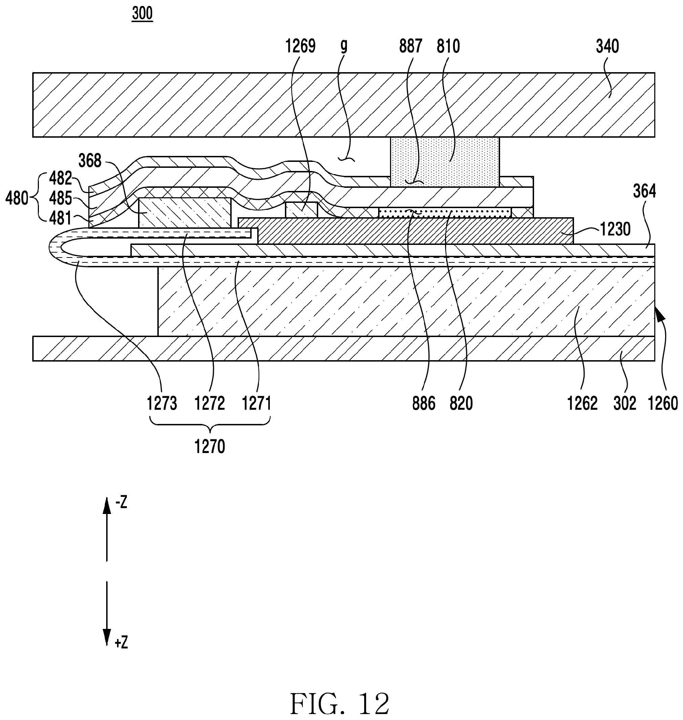

In an embodiment, the display 360 may include a display panel 362 and a conductive sheet 364. In an embodiment, the display panel 362 may be configured to emit light. For example, the display panel 362 may include a liquid crystal display panel or an organic light emitting diode panel. In an embodiment, the display panel 362 may be disposed between the window 302 and the conductive sheet 364. The flexible printed circuit board 330 may be connected to the display panel 362. For example, the flexible printed circuit board 330 may be connected to a base substrate (e.g., a substrate 1270 of FIG. 12) of the display panel 362. The base substrate of the display panel 362 may be formed of plastic or glass such as polyimide, but is not limited thereto. In an embodiment, the conductive sheet 364 may be disposed on a back surface (e.g., in a -Z direction) of the display panel 362. The conductive sheet 364 may include an electrically conductive material. For example, the conductive sheet 364 may include a conductive metal. For example, the conductive sheet 364 may include copper, iron, nickel, or stainless steel, an alloy thereof, or a combination thereof, but is not limited thereto. The conductive sheet 364 may shield an electromagnetic wave that may be emitted from the display 360 or introduced into the display 360. The conductive sheet 364 may be referred to as a metal plate (in a case of being formed of metal), a conductive plate, or a conductive layer.

Although not illustrated, the display 360 may include a support layer (or cover layer) disposed between the display panel 362 and the conductive sheet 364. For example, the support layer may include a cushion layer including a porous structure (e.g., a foam) having elasticity to absorb an impact that may be applied to the display panel 362.

Although not illustrated, in order to sense a touch input from the outside (e.g., through the window 302), the electronic device 300 may include a touch panel disposed on the display panel 362 or integrated into the display panel 362.

In an embodiment, the flexible printed circuit board 330 may be connected to the display panel 362 of the display 360. The flexible printed circuit board 330 may be electrically connected to the display panel 362 of the display 360. In an embodiment, the flexible printed circuit board 330 may include a first portion 332, a second portion 334 extending from the first portion 332, and a third portion 336 extending from the second portion 334 to the display panel 362. The first portion 332 may be formed to be at least partially rigid. The second portion 334 and the third portion 336 may be formed to be substantially flexible. In this respect, the first portion 332 may be referred to as a rigid portion of the flexible printed circuit board 330, the second portion 334, and/or the third portion 336 may be referred to as a flexible portion of the flexible printed circuit board 330.

In an embodiment, the third portion 336 may be bent or folded. For example, the third portion 336 may be bent or folded to connect the display panel 362 and the second portion 334 positioned above the display panel 362. For example, as the third portion 336 is bent or folded, the flexible printed circuit board 330 may overlap the conductive sheet 364. In an embodiment, the flexible printed circuit board 330 may at least partially include the base substrate (e.g., a second portion 1272 and a third portion 1273 of the substrate 1270 of FIG. 12) of the display panel 362. In an embodiment, the second portion 334 and the third portion 336 of the flexible printed circuit board 330 may be at least partially replaced with the base substrate (e.g., the second portion 1272 and the third portion 1273 of the substrate 1270 of FIG. 12) of the display panel 362. With respect to this, it is described later with reference to FIG. 12.

In an embodiment, the flexible printed circuit board 330 may include a section disposed between the display 360 (or the conductive sheet 364) and the support bracket 340, and spaced apart from the support bracket 340. For example, the first portion 332 and the second portion 334 of the flexible printed circuit board 330 may be disposed between the conductive sheet 364 and the support bracket 340. The first portion 332 and the second portion 334 may be spaced apart from the support bracket 340.

In an embodiment, the display driving circuitry 368 may be disposed or mounted on the flexible printed circuit board 330. For example, the display driving circuitry 368 may be disposed on the second portion 334 (e.g., in the -Z direction) of the flexible printed circuit board 330 to face the support bracket 340. The display driving circuitry 368 may generate a signal for driving the display panel 362 (e.g., a voltage signal for controlling activation of pixels of the display panel 362) based on a signal transmitted from a processor (e.g., the processor 120 of FIG. 1) of the electronic device 300. In an embodiment, the display driving circuitry 368 may be referred to as a display driving chip (or package).

In an embodiment, the display 360 may be understood to include at least one of the window 302, the display panel 362, the conductive sheet 364, the display driving circuitry 368, and/or the flexible printed circuit board 330, or may be referred to as a display assembly including the same.

In an embodiment, the support bracket 340 may be disposed on the display 360 (e.g., in the -Z direction). In an embodiment, the support bracket 340 may support the display 360. Although in FIG. 3, the support bracket 340 and the display 360 are illustrated as being spaced apart, the support bracket 340 may physically support the display 360 either directly (e.g., through another portion of the support bracket 340 not illustrated) or indirectly (e.g., through another member distinct from the support bracket 340). For example, the support bracket 340 may indirectly support the display 360 by directly supporting the window 302 to which the display 360 is attached. In an embodiment, the support bracket 340 may include a conductive portion formed of a conductive metal such as aluminum, magnesium, or titanium.

In order to transmit various signals to the display 360, numerous wirings may be formed on the flexible printed circuit board 330. Accordingly, noise (e.g., electromagnetic interference (EMI)) may be generated from the flexible printed circuit board 330, especially the display driving circuitry 368 mounted on the flexible printed circuit board 330. The generated noise may have a negative effect on a peripheral configuration of the flexible printed circuit board 330. For example, noise generated from the flexible printed circuit board 330 may have an effect on performance of an antenna using the conductive portion of the support bracket 340 (e.g., the second part 243 of FIG. 2B). With reference to the following drawings, examples of the electronic device 300 for efficiently shielding such noise are described.

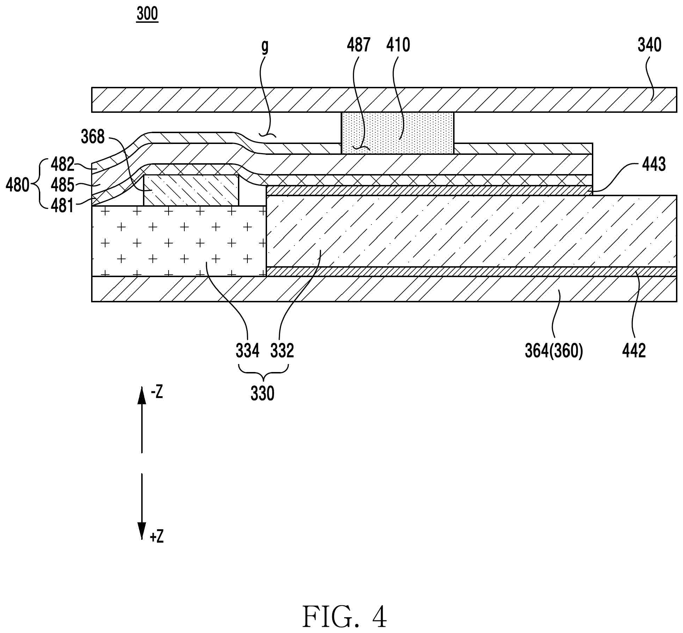

FIG. 4 is an exemplary cross-sectional view of an electronic device according to an embodiment.

Referring to FIG. 4, a flexible printed circuit board 330 of an electronic device 300 may be disposed between a display 360 and a support bracket 340. For example, the flexible printed circuit board 330 may be disposed between the support bracket 340 and the display 360 to be spaced apart from the support bracket 340.

In an embodiment, the flexible printed circuit board 330 may include a front surface (e.g., a surface facing a +Z direction) and a rear surface (e.g., a surface facing a -Z direction) opposite to the front surface. The front surface and the rear surface of a first portion 332 may include conductive regions formed of a conductive material, such as copper or gold, to allow electrical contact with the flexible printed circuit board 330, and non-conductive regions formed of a non-conductive material, such as solder resist.

The electronic device 300 (or the display assembly) according to an embodiment may include a shielding layer (or shielding member) 480. The shielding layer 480 may be spaced apart from the support bracket 340. For example, a gap g may be formed between the shielding layer 480 and the support bracket 340. The gap g may reduce or prevent damage to the flexible printed circuit board 330 and the display 360 due to an external impact such as pressing. In an embodiment, the shielding layer 480 may include a conductive layer 485. The conductive layer 485 may be formed of, for example, a material having electrical conductivity. For example, the conductive layer 485 may be formed of metal such as copper, a conductive fabric, or a combination thereof, but is not limited thereto. The conductive layer 485 may be referred to as a shielding sheet or a shielding layer.

In an embodiment, the shielding layer 480 (or the conductive layer 485) may be disposed on the flexible printed circuit board 330 to cover display driving circuitry 368. For example, the shielding layer 480 may be disposed on the rear surface of the flexible printed circuit board 330 to cover the display driving circuitry 368. For example, the shielding layer 480 may be attached on the rear surface of the flexible printed circuit board 330 through an adhesive member such as a pressure-sensitive adhesive. The shielding layer 480 may shield noise that may be generated from the display driving circuitry 368 or introduced into the display driving circuitry 368. For example, the shielding layer 480 may reduce or block radio frequency (RF) mixing noise that may be generated by an operation of the display 360. For example, the shielding layer 480 may reduce or block noise generated by an operation of the display 360 from being reinduced into an antenna (e.g., an antenna using the second part 243 of FIG. 2B) of the electronic device 300.

In an embodiment, the shielding layer 480 may further include a first non-conductive layer 481 and/or a second non-conductive layer 482. The conductive layer 485 may be disposed between the first non-conductive layer 481 and the second non-conductive layer 482. For example, the first non-conductive layer 481 may be disposed on a front surface (e.g., a surface facing the +Z direction) of the conductive layer 485, and the second non-conductive layer 482 may be disposed on the rear surface (e.g., a surface facing the -Z direction) of the conductive layer 485. In an embodiment, each of the first non-conductive layer 481 and the second non-conductive layer 482 may be attached to the conductive layer 485 through an adhesive material (or member) such as a pressure-sensitive adhesive or a conductive pressure-sensitive adhesive. The first non-conductive layer 481 and the second non-conductive layer 482 may be formed of a material having electrical non-conductivity. For example, the first non-conductive layer 481 and the second non-conductive layer 482 may be formed of a resin such as polyethylene terephthalate (PET), but are not limited thereto. The first non-conductive layer 481 and the second non-conductive layer 482 may be referred to as a first insulating layer and a second insulating layer, respectively.

In an embodiment, the electronic device 300 (or the flexible printed circuit board 330) may include a first shielding tape 442 and a second shielding tape 443. The first shielding tape 442 may be attached on the front surface of the first portion 332 of the flexible printed circuit board 330. The first shielding tape 442 may at least partially cover the front surface of the first portion 332 of the flexible printed circuit board 330. In an embodiment, the first shielding tape 442 may be disposed on a conductive sheet 364. The first shielding tape 442 may be attached to the conductive sheet 364 by using a conductive adhesive or an insulating adhesive. Optionally, the first shielding tape 442 may be further formed on the front surface of a second portion 334 of the flexible printed circuit board 330. In an embodiment, the second shielding tape 443 may be attached on the rear surface of the first portion 332 of the flexible printed circuit board 330. The second shielding tape 443 may at least partially cover the rear surface of the first portion 332 of the flexible printed circuit board 330. A portion of the shielding layer 480 may be disposed (e.g., attached) on the second shielding tape 443. Each of the first shielding tape 442 and the second shielding tape 443 may be referred to as an electromagnetic interference (EMI) shielding sheet. Although not illustrated, in order to electrically connect the second shielding tape 443 to the flexible printed circuit board 330, the electronic device 300 may include a conductive tape disposed between the second shielding tape 443 and the flexible printed circuit board 330.

The electronic device 300 according to an embodiment may include a first conductive gasket 410. In an embodiment, the first conductive gasket 410 may be disposed between the support bracket 340 and the shielding layer 480. For example, the first conductive gasket 410 may be disposed (or interposed) between the conductive portion of the support bracket 340 and the conductive layer 485 of the shielding layer 480. For example, the first conductive gasket 410 may extend from the conductive portion of the support bracket 340 to the conductive layer 485 of the shielding layer 480.

In an embodiment, the first conductive gasket 410 may electrically connect the shielding layer 480 (or the conductive layer 485) and the support bracket 340. For example, the first conductive gasket 410 may be in direct or indirect (e.g., through another component not illustrated) contact with the conductive portion of the support bracket 340 and/or the conductive layer 485 of the shielding layer 480. For example, the first conductive gasket 410 may be welded to the conductive portion of the support bracket 340. Additionally or optionally, a metal sheet may be disposed (or interposed) between the first conductive gasket 410 and the support bracket 340. The metal sheet may include a weldable metal or metal alloy. The metal sheet may be provided to weld the first conductive gasket 410 and the support bracket 340, but is not limited thereto. For example, the metal sheet may be attached to the first conductive gasket 410 and/or the support bracket 340 through a conductive adhesive. For another example, the first conductive gasket 410 may be attached to the support bracket 340 through a conductive adhesive. For example, the first conductive gasket 410 may form surface contact or point contact with the conductive layer 485. For another example, the first conductive gasket 410 may be attached to the conductive layer 485 through a conductive adhesive.

In an embodiment, an opening 487 may be formed in the second non-conductive layer 482 to allow the first conductive gasket 410 to contact the conductive layer 485. The opening 487 may be a hole penetrating the second non-conductive layer 482. Unlike the illustration, the opening 487 may be formed as a periphery of the second non-conductive layer 482 is notched or chamfered, or may be a slot formed as a result.

In an embodiment, the first conductive gasket 410 may be formed to have a thickness greater than the gap g. For example, with respect to a direction perpendicular to the display 360 (e.g., a Z-axis direction), a length of the first conductive gasket 410 may be greater than a length of the gap.

In an embodiment, in order to provide an electrical path, the first conductive gasket 410 may include a material having electrical conductivity. In addition, the first conductive gasket 410 may be configured to have elasticity. For example, the first conductive gasket 410 may include an elastic material (e.g., a foam) and a conductive material (e.g., a conductive fabric) surrounding the elastic material. For example, the first conductive gasket 410 may include a urethane fabric nickel (UFN) gasket. For example, the first conductive gasket 410 may include a conductive foam, a conductive fabric, a conductive tape, or a step compensation tape. For example, the first conductive gasket 410 may include a foam or a conductive foam surrounded by or coated with a conductive material, such as a conductive fabric-over-foam gasket. In an embodiment, the first conductive gasket 410 may be referred to as an electrical connection member, a conductive elastic member, a conductive interface, or an electrical interface.

In an embodiment, as the shielding layer 480 is electrically connected to the support bracket 340 by the first conductive gasket 410, shielding performance of the shielding layer 480 may be improved. It may be because the support bracket 340 operates as a ground for noise induced into the shielding layer 480. Accordingly, performance degradation of a peripheral component, such as an antenna using the support bracket 340, due to noise, may be reduced. In addition, since the first conductive gasket 410 provides elasticity by being positioned between the support bracket 340 and the display 360, reliability of an electrical connection between the shielding layer 480 and the support bracket 340 may be improved. Accordingly, it may reduce a performance deviation of a peripheral component such as an antenna using the support bracket 340, due to a performance deviation of the shielding layer 480. In addition, since the first conductive gasket 410 provides elasticity between the display 360 and the support bracket 340 by being disposed on the first portion 332 of the relatively rigid flexible printed circuit board 330, it may reduce or prevent a back surface (e.g., a surface facing the -Z direction) of the display 360 from being pressed or occurrence of a crack by an external impact.

In an embodiment, the electrical connection structure between the conductive layer 485, the first conductive gasket 410, and the support bracket 340 described with reference to FIG. 4 may be referred to as a first ground connection structure of the electronic device 300.

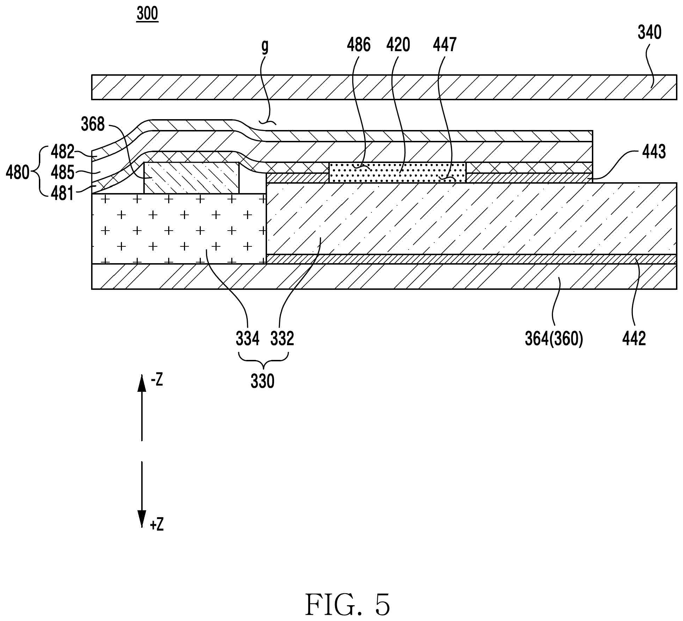

FIG. 5 is an exemplary cross-sectional view of an electronic device according to an embodiment.

Referring to FIG. 5, an electronic device 300 according to an embodiment may include a second conductive gasket 420. In an embodiment, the second conductive gasket 420 may be disposed between a shielding layer 480 and a flexible printed circuit board 330. For example, the second conductive gasket 420 may be disposed (or interposed) between a conductive layer 485 of the shielding layer 480 and a first portion 332 of the flexible printed circuit board 330.

In an embodiment, the second conductive gasket 420 may electrically connect the shielding layer 480 and the flexible printed circuit board 330. For example, the second conductive gasket 420 may be in direct or indirect (e.g., through another component not illustrated) contact with the conductive layer 485 of the shielding layer 480 and/or a conductive region formed on the rear surface of the first portion 332 of the flexible printed circuit board 330. For example, the second conductive gasket 420 may be soldered to the conductive region of the flexible printed circuit board 330 (e.g., a surface mount technology (SMT)). For another example, the second conductive gasket 420 may be attached to the conductive region of the flexible printed circuit board 330 through a conductive adhesive. For example, the second conductive gasket 420 may form surface contact or point contact with the conductive layer 485. For another example, the second conductive gasket 420 may be attached to the conductive layer 485 through a conductive adhesive. In an embodiment, the shielding layer 480 may be electrically connected to a ground of the flexible printed circuit board 330 through the second conductive gasket 420.

In an embodiment, an opening 486 may be formed in a first non-conductive layer 481 to allow the second conductive gasket 420 to contact the conductive layer 485. The second conductive gasket 420 may be positioned in the opening 486. The opening 486 may be a hole penetrating the first non-conductive layer 481. Unlike the illustration, the opening 486 may be formed as a periphery of the first non-conductive layer 481 is notched or chamfered, or may be a slot formed as a result.

In an embodiment, an opening 447 may be formed in a second shielding tape 443 to allow the second conductive gasket 420 to contact the flexible printed circuit board 330. The opening 447 of the second shielding tape 443 may be at least partially aligned or overlapped with the opening 486 of the first non-conductive layer 481. The opening 447 may be a hole penetrating the second shielding tape 443. Unlike the illustration, the opening 447 may be formed as a periphery of the second shielding tape 443 is notched or chamfered, or may be a slot formed as a result.

In an embodiment, the second conductive gasket 420 may be positioned in the opening 486 and the opening 447. The second conductive gasket 420 may extend from the conductive layer 485 to the first portion 332 of the flexible printed circuit board 330 by penetrating the first non-conductive layer 481 and the second shielding tape 443.

In an embodiment, in order to provide an electrical path, the second conductive gasket 420 may include a material having electrical conductivity. Additionally, or optionally, the second conductive gasket 420 may be configured to have elasticity. In an embodiment, the second conductive gasket 420 may include a step compensation tape, a conductive foam, a conductive tape, or a conductive fabric, but is not limited thereto. For example, the second conductive gasket 420 may include a foam or a conductive foam surrounded by or coated with a conductive material, such as a conductive fabric-over-foam gasket. In an embodiment, the second conductive gasket 420 may be referred to as a conductive adhesive member, an electrical connection member, a conductive elastic member (e.g., in a case of having elasticity), a conductive interface, or an electrical interface.

In an embodiment, as the shielding layer 480 is electrically connected to the ground of the flexible printed circuit board 330 by the second conductive gasket 420, shielding performance of the shielding layer 480 may be improved. Accordingly, performance degradation of a peripheral component, such as an antenna using a support bracket 340, due to noise, may be reduced.

In an embodiment, the electrical connection structure between the conductive layer 485, the second conductive gasket 420, and the flexible printed circuit board 330 described with reference to FIG. 5 may be referred to as a second ground connection structure of the electronic device 300.

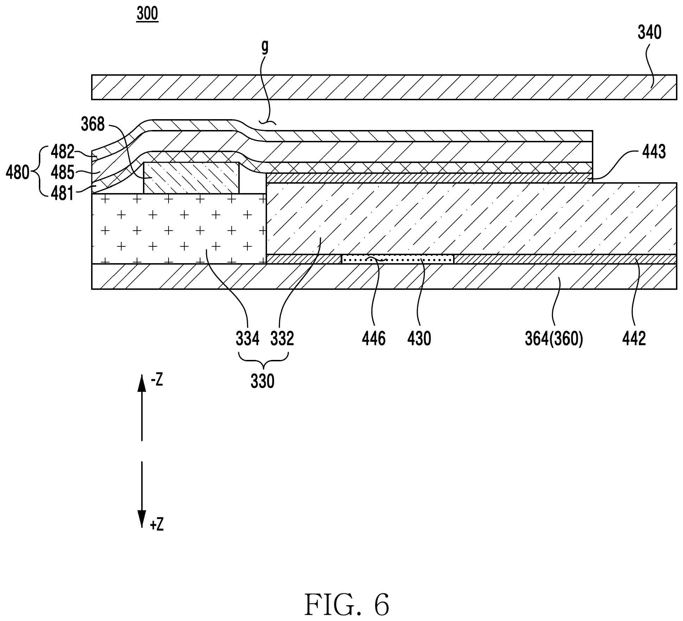

FIG. 6 is an exemplary cross-sectional view of an electronic device according to an embodiment.

Referring to FIG. 6, an electronic device 300 according to an embodiment may include a third conductive gasket 430. In an embodiment, the third conductive gasket 430 may be disposed between a flexible printed circuit board 330 and a display 360. For example, the third conductive gasket 430 may be disposed (or interposed) between a first portion 332 of the flexible printed circuit board 330 and a conductive sheet 364 of the display 360. For example, the third conductive gasket 430 may extend from the first portion 332 of the flexible printed circuit board 330 to the conductive sheet 364 of the display 360.

In an embodiment, the third conductive gasket 430 may electrically connect the flexible printed circuit board 330 and the conductive sheet 364. For example, the third conductive gasket 430 may be in direct or indirect (e.g., through another member not illustrated) contact with a conductive region formed on the front surface of the first portion 332 of the flexible printed circuit board 330 and/or the conductive sheet 364 of the display 360. For example, the third conductive gasket 430 may be soldered to the conductive region of the front surface of the flexible printed circuit board 330 (e.g., an SMT). For another example, the third conductive gasket 430 may be attached to the conductive region of the flexible printed circuit board 330 through a conductive adhesive. For example, the third conductive gasket 430 may be in direct contact with the conductive sheet 364 or may be attached to the conductive sheet 364 through a conductive adhesive.

In an embodiment, the conductive sheet 364 may be electrically connected to a ground of the flexible printed circuit board 330 through the third conductive gasket 430. Accordingly, a ground area of the electronic device 300 may be increased.

In an embodiment, an opening 446 may be formed in a first shielding tape 442 to allow the third conductive gasket 430 to contact the flexible printed circuit board 330. The opening 446 may be a hole penetrating the first shielding tape 442. Unlike the illustration, the opening 446 may be formed as a periphery of the first shielding tape 442 is notched or chamfered, or may be a slot formed as a result. In an embodiment, the third conductive gasket 430 may be positioned in the opening 446. The third conductive gasket 430 may penetrate the first shielding tape 442.

In an embodiment, in order to provide an electrical path, the third conductive gasket 430 may include a material having electrical conductivity. Additionally, or optionally, the third conductive gasket 430 may be configured to have elasticity. In an embodiment, the third conductive gasket 430 may include a step compensation tape, a conductive foam, a conductive tape, or a conductive fabric, but is not limited thereto. For example, the third conductive gasket 430 may include a foam or a conductive foam surrounded by or coated with a conductive material, such as a conductive fabric-over-foam gasket. In an embodiment, the third conductive gasket 430 may be referred to as a conductive adhesive member, an electrical connection member, a conductive elastic member (e.g., in a case of having elasticity), a conductive interface, or an electrical interface.

In an embodiment, the electrical connection structure between the flexible printed circuit board 330, the third conductive gasket 430, and the conductive sheet 364 described with reference to FIG. 6 may be referred to as a third ground connection structure of the electronic device 300.

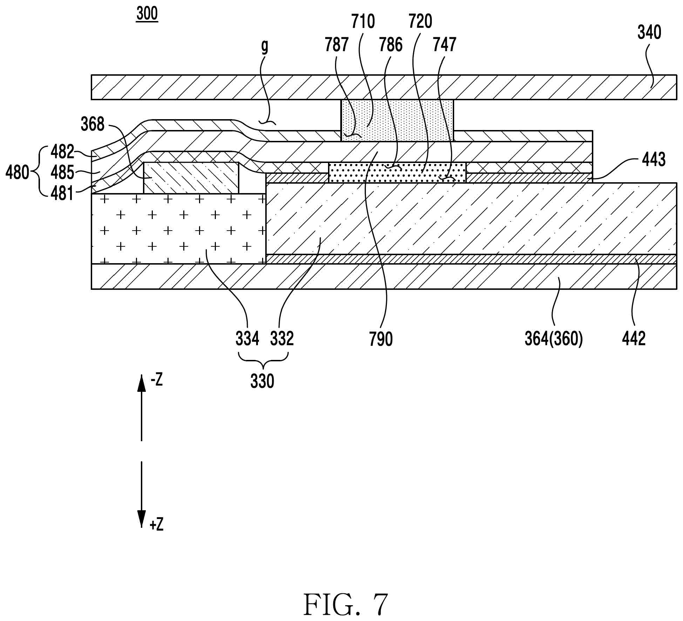

FIG. 7 is an exemplary cross-sectional view of an electronic device according to an embodiment.

Referring to FIG. 7, an electronic device 300 according to an embodiment may include a first conductive gasket 710 and a second conductive gasket 720.

In an embodiment, with respect to the first conductive gasket 710, the description provided with reference to the first conductive gasket 410 of FIG. 4 may be applied in a substantially same or corresponding manner. For example, the first conductive gasket 710 may be disposed (or interposed) between the conductive portion of a support bracket 340 and a conductive layer 485 of a shielding layer 480. For example, the first conductive gasket 710 may electrically connect the conductive layer 485 of the shielding layer 480 and the support bracket 340. For example, the first conductive gasket 710 may be formed to have a thickness greater than a gap g. For example, the first conductive gasket 710 may extend from the conductive portion of the support bracket 340 to the conductive layer 485 of the shielding layer 480 by penetrating an opening 787 formed in a second non-conductive layer 482. For example, the first conductive gasket 710 may be configured to have electrical conductivity and elasticity. For example, the first conductive gasket 710 may include a urethane fabric nickel (UFN) gasket. For example, the first conductive gasket 710 may include a conductive fabric-over-foam gasket, a conductive foam, a conductive fabric, a conductive tape, or a step compensation tape. In an embodiment, the first conductive gasket 710 may be referred to as an electrical connection member, a conductive elastic member, a conductive interface, or an electrical interface.

In an embodiment, with respect to the opening 787 of the second non-conductive layer 482, the description provided with reference to the opening 487 of the second non-conductive layer 482 of FIG. 4 may be applied in a substantially same or corresponding manner. For example, as the conductive layer 485 is exposed to the outside of the shielding layer 480 through the opening 787 of the second non-conductive layer 482, it may allow the first conductive gasket 710 to access the conductive layer 485. For example, the opening 787 may be a hole penetrating the second non-conductive layer 482, and for another example, unlike the illustration, the opening 787 may be formed as a periphery of the second non-conductive layer 482 is notched or chamfered, or may be a slot formed as a result.

In an embodiment, with respect to the second conductive gasket 720, the description provided with reference to the second conductive gasket 420 of FIG. 5 may be applied in a substantially same or corresponding manner. For example, by being disposed (or interposed) between the conductive layer 485 of the shielding layer 480 and a first portion 332 of a flexible printed circuit board 330, the second conductive gasket 720 may electrically connect them. For example, the second conductive gasket 720 may be in direct or indirect contact with the conductive layer 485 of the shielding layer 480 and/or a conductive region formed on the rear surface of the first portion 332 of the flexible printed circuit board 330. The shielding layer 480 may be electrically connected to a ground of the flexible printed circuit board 330 through the second conductive gasket 720. For example, the second conductive gasket 720 may be configured to have electrical conductivity. Additionally or optionally, the second conductive gasket 720 may be configured to have elasticity. For example, the second conductive gasket 720 may include a conductive fabric-over-foam gasket, a step compensation tape, a conductive foam, a conductive tape, or a conductive fabric, but is not limited thereto. In an embodiment, the second conductive gasket 720 may be referred to as a conductive adhesive member, an electrical connection member, a conductive elastic member (e.g., in a case of having elasticity), a conductive interface, or an electrical interface.

In an embodiment, the second conductive gasket 720 may be positioned in an opening 786 formed in a first non-conductive layer 481 and an opening 747 formed in a second shielding tape 443.

In an embodiment, materials and/or sizes of the first conductive gasket 710 and the second conductive gasket 720 may be different. For example, the first conductive gasket 710 may include a conductive foam coated with a conductive material, and the second conductive gasket 720 may include a conductive fabric. For example, a thickness (e.g., a length in a Z-axis direction) of the first conductive gasket 710 may be greater than a thickness of the second conductive gasket 720. However, it is not limited by the above-described example.

In an embodiment, with respect to the opening 786, the description of the opening 486 provided with reference to FIG. 5 may be applied in a substantially same or corresponding manner. For example, as the conductive layer 485 is exposed to the outside of the shielding layer 480 through the opening 786 of the first non-conductive layer 481, it may allow the second conductive gasket 720 to contact the conductive layer 485. For example, the opening 786 may be a hole penetrating the first non-conductive layer 481. For another example, unlike the illustration, the opening 786 may be formed as a periphery of the first non-conductive layer 481 is notched or chamfered, or may be a slot formed as a result.

In an embodiment, with respect to the opening 747, the description of the opening 447 provided with reference to FIG. 5 may be applied in a substantially same or corresponding manner. For example, as the conductive region of the flexible printed circuit board 330 is exposed to the outside of the second shielding tape 443 through the opening 747 of the second shielding tape 443, it may allow the second conductive gasket 720 to contact the conductive region of the flexible printed circuit board 330. For example, the opening 747 of the second shielding tape 443 may be at least partially aligned or overlapped with the opening 786 of the first non-conductive layer 481. For example, the opening 747 may be a hole penetrating the second shielding tape 443. For another example, unlike the illustration, the opening 747 may be formed as a periphery of the second shielding tape 443 is notched or chamfered, or may be a slot formed as a result.

In an embodiment, the first conductive gasket 710 may at least partially overlap the second conductive gasket 720. For example, the first conductive gasket 710 may at least partially overlap the second conductive gasket 720 with respect to a direction (e.g., the Z-axis direction) perpendicular to the support bracket 340. The openings 747, 786, and 787 for accommodating the first conductive gasket 710 and the second conductive gasket 720 may also at least partially overlap each other.

In an embodiment, the first conductive gasket 710 may provide a force (e.g., an elastic force) according to a vertical direction (e.g., the Z-axis direction). For example, the first conductive gasket 710 may provide a force in a direction toward the second conductive gasket 720 overlapping the first conductive gasket 710. For example, the conductive layer 485 may include a section 790 disposed (or interposed) between the first conductive gasket 710 and the second conductive gasket 720. The first conductive gasket 710 may provide an elastic force to the section 790 of the conductive layer 485 with which the second conductive gasket 720 is in direct or indirect contact. The elastic force from the first conductive gasket 710 may be transferred to the second conductive gasket 720 through the section 790. Accordingly, stability of an electrical connection through the first conductive gasket 710 and the second conductive gasket 720 may be improved. In addition, as the conductive layer 485 is electrically connected to the support bracket 340 and the ground of the flexible printed circuit board 330 through an electrical connection structure having orthogonality, which is provided by the first conductive gasket 710 and the second conductive gasket 720, shielding performance of the conductive layer 485 may be improved. Accordingly, due to noise of components such as the flexible printed circuit board 330 and display driving circuitry 368 disposed thereon, performance deviation and degradation of a peripheral component such as an antenna using the support bracket 340 may be reduced.

In an embodiment, the electrical connection structure between the support bracket 340, the first conductive gasket 710, the conductive layer 485, the second conductive gasket 720, and the flexible printed circuit board 330 described with reference to FIG. 7 may be referred to as a fourth ground connection structure of the electronic device 300. The fourth ground connection structure may include the first ground connection structure (e.g., FIG. 4) and the second ground connection structure (e.g., FIG. 5).

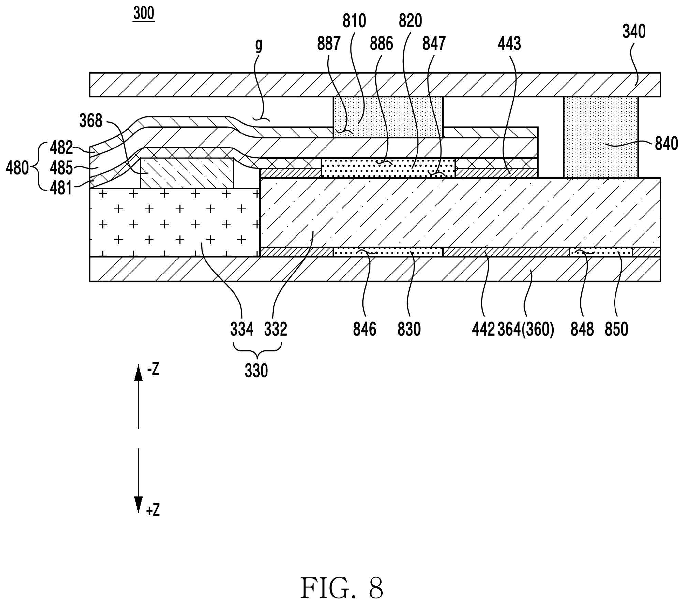

FIG. 8 is an exemplary cross-sectional view of an electronic device according to an embodiment.

Referring to FIG. 8, an electronic device 300 according to an embodiment may include a first conductive gasket 810, a second conductive gasket 820, and a third conductive gasket 830.

In an embodiment, with respect to the first conductive gasket 810, the description provided with reference to the first conductive gasket 410 of FIG. 4 and/or the first conductive gasket 710 of FIG. 7 may be applied in a substantially same or corresponding manner. For example, by being disposed (or interposed) between the conductive portion of a support bracket 340 and a conductive layer 485, the first conductive gasket 810 may electrically connect them. The first conductive gasket 810 may be positioned in an opening 887 formed in a second non-conductive layer 482. With respect to the opening 887, the description provided with reference to the opening 487 of FIG. 4 and/or the opening 787 of FIG. 7 may be applied in a substantially same or corresponding manner.

In an embodiment, with respect to the second conductive gasket 820, the description provided with reference to the second conductive gasket 420 of FIG. 4 and/or the second conductive gasket 720 of FIG. 7 may be applied in a substantially same or corresponding manner. For example, by being disposed (or interposed) between the conductive layer 485 and a first portion 332 of a flexible printed circuit board 330 (or a conductive region of the first portion 332), the second conductive gasket 820 may electrically connect them. The second conductive gasket 820 may be positioned in an opening 886 formed in a first non-conductive layer 481 and an opening 847 formed in a second shielding tape 443. With respect to the opening 886, the description provided with reference to the opening 486 of FIG. 4 and/or the opening 786 of FIG. 7 may be applied in a substantially same or corresponding manner, and for the opening 847, the description provided with reference to the opening 447 of FIG. 5 and/or the opening 747 of FIG. 7 may be applied in a substantially same or corresponding manner.

In an embodiment, with respect to the third conductive gasket 830, the description provided with reference to the third conductive gasket 430 of FIG. 6 may be applied in a substantially same or corresponding manner. For example, by being disposed (or interposed) between the first portion 332 of the flexible printed circuit board 330 and a conductive sheet 364 of a display 360, the third conductive gasket 830 may electrically connect them. In an embodiment, in order to provide an electrical path, the third conductive gasket 830 may include a material having electrical conductivity. Additionally, or optionally, the third conductive gasket 830 may be configured to have elasticity. In an embodiment, the third conductive gasket 830 may include a conductive fabric-over-foam gasket, a step compensation tape, a conductive foam, a conductive tape, or a conductive fabric, but is not limited thereto. In an embodiment, the third conductive gasket 830 may be referred to as a conductive adhesive member, an electrical connection member, a conductive elastic member (e.g., in a case of having elasticity), a conductive interface, or an electrical interface. In an embodiment, the third conductive gasket 830 may be positioned in an opening 846 formed in a first shielding tape 442. With respect to the opening 846, the description provided with reference to the opening 446 of FIG. 6 may be applied in a substantially same or corresponding manner. For example, the opening 846 may be a hole penetrating the first shielding tape 442. Unlike the illustration, the opening 846 may be formed as a periphery of the first shielding tape 442 is notched or chamfered, or may be a slot formed as a result.

In an embodiment, the first conductive gasket 810 may at least partially overlap the second conductive gasket 820 and the third conductive gasket 830. For example, the first conductive gasket 810 may at least partially overlap the second conductive gasket 820 and the third conductive gasket 830 with respect to a direction (e.g., a Z-axis direction) perpendicular to the support bracket 340. The openings 846, 847, 886, and 887 that accommodate the first conductive gasket 810, the second conductive gasket 820, and the third conductive gasket 830 may also at least partially overlap each other.

In an embodiment, the first conductive gasket 810 may provide an elastic force to the second conductive gasket 820 and the third conductive gasket 830. Accordingly, stability of an electrical connection through the second conductive gasket 820 and the third conductive gasket 830 may be improved.

The electronic device 300 according to an embodiment may include a fourth conductive gasket 840. Additionally, the electronic device 300 may include a fifth conductive gasket 850. In an embodiment, the fourth conductive gasket 840 may be spaced apart from the first conductive gasket 810. The fourth conductive gasket 840 may be positioned outside the shielding layer 480. The fourth conductive gasket 840 may extend from the support bracket 340 to the first portion 332 of the flexible printed circuit board 330.

In an embodiment, the fourth conductive gasket 840 may be disposed between the support bracket 340 and the flexible printed circuit board 330. For example, the fourth conductive gasket 840 may be disposed between the conductive portion of the support bracket 340 and the first portion 332 of the flexible printed circuit board 330. For example, the fourth conductive gasket 840 may be disposed (or interposed) between the conductive portion of the support bracket 340 and a conductive region formed on the rear surface of the first portion 332 of the flexible printed circuit board 330.

In an embodiment, the fourth conductive gasket 840 may electrically connect the conductive portion of the support bracket 340 and the conductive region of the first portion 332 of the flexible printed circuit board 330. In order to provide such an electrical connection, the fourth conductive gasket 840 may be in direct or indirect (e.g., through another member not illustrated) contact with the conductive region of the support bracket 340 and/or the conductive region of the first portion 332 of the flexible printed circuit board 330. For example, the fourth conductive gasket 840 may be welded to the conductive portion of the support bracket 340. Additionally or optionally, a metal sheet may be disposed (or interposed) between the fourth conductive gasket 840 and the support bracket 340. The metal sheet may include a weldable metal or metal alloy. The metal sheet may be provided for welding the fourth conductive gasket 840 and the support bracket 340, but is not limited thereto. For example, the metal sheet may be attached to the fourth conductive gasket 840 and/or the support bracket 340 through a conductive adhesive. For another example, the fourth conductive gasket 840 may be attached to the support bracket 340 through a conductive adhesive. For example, the fourth conductive gasket 840 may be soldered on the first portion 332 of the flexible printed circuit board 330 (e.g., an SMT). For another example, the fourth conductive gasket 840 may be attached on the first portion 332 of the flexible printed circuit board 330 through a conductive adhesive.

In an embodiment, the fourth conductive gasket 840 may include a material having electrical conductivity. Additionally, or optionally, the fourth conductive gasket 840 may be configured to have elasticity. For example, the fourth conductive gasket 840 may include an elastic material (e.g., a foam) and a conductive material (e.g., a conductive fabric) surrounding the elastic material, but is not limited thereto. For example, the fourth conductive gasket 840 may include a UFN gasket, a conductive fabric-over-foam gasket, a step compensation tape, a conductive foam, a conductive fabric, or a conductive tape. In an embodiment, the fourth conductive gasket 840 may be referred to as a conductive adhesive member, an electrical connection member, a conductive elastic member (e.g., in a case of having elasticity), a conductive interface, or an electrical interface.

In an embodiment, with respect to the fifth conductive gasket 850, the description provided with reference to the third conductive gasket 430 of FIG. 6 may be applied in a substantially same or corresponding manner. For example, by being disposed (or interposed) between the first portion 332 of the flexible printed circuit board 330 and the conductive sheet 364 of the display 360, the fifth conductive gasket 850 may electrically connect them. In an embodiment, in order to provide an electrical path, the fifth conductive gasket 850 may include a material having electrical conductivity. Additionally, or optionally, the fifth conductive gasket 850 may be configured to have elasticity. In an embodiment, the fifth conductive gasket 850 may include a conductive fabric-over-foam gasket, a step compensation tape, a conductive foam, a conductive tape, or a conductive fabric, but is not limited thereto. In an embodiment, the fifth conductive gasket 850 may be referred to as a conductive adhesive member, an electrical connection member, a conductive elastic member (e.g., in a case of having elasticity), a conductive interface, or an electrical interface. In an embodiment, the fifth conductive gasket 850 may be positioned in an opening 848 formed in the first shielding tape 442. With respect to the opening 848, the description provided with reference to the opening 446 of FIG. 6 may be applied in a substantially same or corresponding manner. For example, the opening 848 may be a hole penetrating the first shielding tape 442. Unlike the illustration, the opening 848 may be formed as a periphery of the first shielding tape 442 is notched or chamfered, or may be a slot formed as a result.

In an embodiment, the fourth conductive gasket 840 may at least partially overlap the fifth conductive gasket 850. For example, the fourth conductive gasket 840 may at least partially overlap the fifth conductive gasket 850 with respect to a direction (e.g., the Z-axis direction) perpendicular to the support bracket 340. In an embodiment, the fourth conductive gasket 840 may provide an elastic force to the fifth conductive gasket 850 by being pressed by the support bracket 340. Accordingly, stability of an electrical connection through the fourth conductive gasket 840 and the fifth conductive gasket 850 may be improved.

In an embodiment, the electrical connection structure between the support bracket 340, the first conductive gasket 810, the conductive layer 485, the second conductive gasket 820, the flexible printed circuit board 330, the third conductive gasket 830, and the conductive sheet 364, described with reference to FIG. 8, may be referred to as a fifth ground connection structure of the electronic device 300. The fifth ground connection structure may include the first ground connection structure (e.g., FIG. 4), the second ground connection structure (e.g., FIG. 5), and the third ground connection structure (e.g., FIG. 6).

Alternatively or optionally, the fifth ground connection structure may not include the first conductive gasket 810. The fifth ground connection structure that does not include the first conductive gasket 810 may be referred to as a sixth ground connection structure.

In an embodiment, the electrical connection structure between the support bracket 340, the fourth conductive gasket 840, and the flexible printed circuit board 330 described with reference to FIG. 8 may be referred to as a seventh ground connection structure of the electronic device 300.

The electrical connection structure between the support bracket 340, the fourth conductive gasket 840, the flexible printed circuit board 330, the fifth conductive gasket 850, and the conductive sheet 364 described with reference to FIG. 8 may be referred to as an eighth ground connection structure of the electronic device 300. The eighth ground connection structure may include an electrical path provided by the fifth conductive gasket 850 in addition to the seventh ground connection structure.

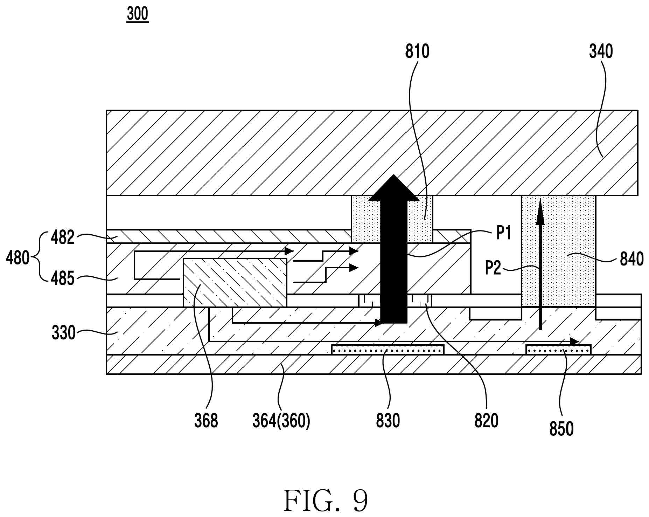

FIG. 9 is an exemplary diagram for describing a flow of a noise signal of an electronic device according to an embodiment.

Referring to FIG. 9, noise from display driving circuitry 368 and/or noise to the display driving circuitry 368 may flow to a support bracket 340 through a conductive layer 485 of a shielding layer 480 and a flexible printed circuit board 330. For example, the noise of the display driving circuitry 368 may be induced into the support bracket 340 through a vertical ground path provided by a first conductive gasket 810, a second conductive gasket 820, and a third conductive gasket 830, such as a first path P1. For example, the noise of the display driving circuitry 368 may be induced into the support bracket 340 through a vertical ground path provided by a fourth conductive gasket 840 and a fifth conductive gasket 850, such as a second path P2. Accordingly, it may reduce or block the noise caused by the display driving circuitry 368 (hereinafter, display driving integrated circuitry (DDIC)) from being induced into another configuration (e.g., an antenna using the second part 243 of FIG. 2B) of an electronic device 300.

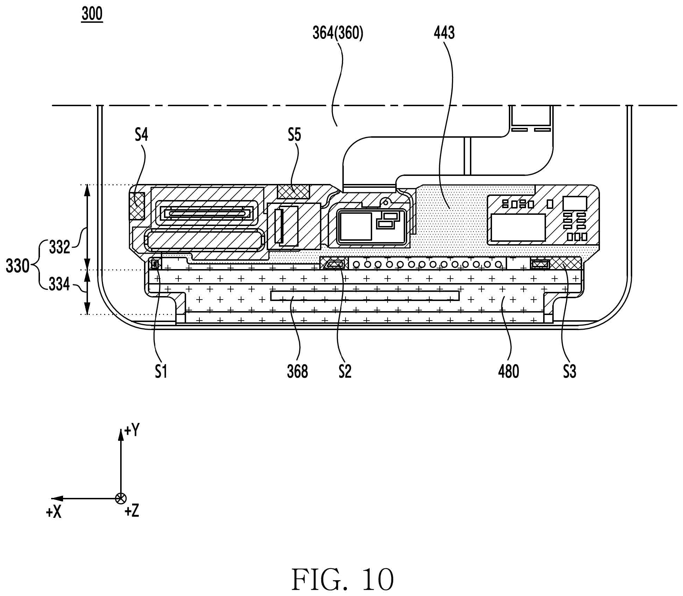

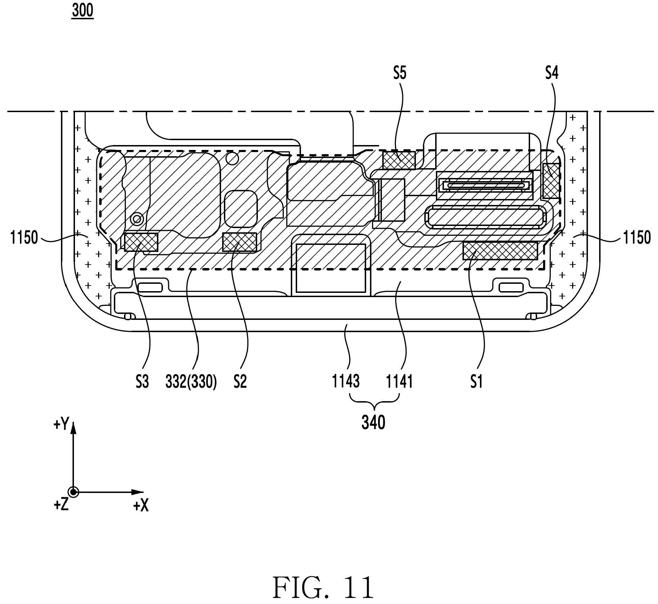

FIGS. 10 and 11 are exemplary diagrams illustrating an electronic device according to an embodiment. FIG. 10 is a diagram in which a back surface of a display 360 is viewed, and FIG. 11 is a diagram illustrating a first portion 332 of a flexible printed circuit board 330 projected onto a support bracket 340.

Referring to FIGS. 10 and 11, an electronic device 300 according to an embodiment may include one or more ground connection structures. The one or more ground connection structures may include at least one of the first ground connection structure of FIG. 4, the second ground connection structure of FIG. 5, the third ground connection structure of FIG. 6, the fourth ground connection structure of FIG. 7, the fifth ground connection structure of FIG. 8, the sixth ground connection structure of FIG. 8, the seventh ground connection structure of FIG. 8, and/or the eighth ground connection structure of FIG. 8. For example, the one or more ground connection structures may include, for example, first to fifth structures S1, S2, S3, S4, and S5.

In an embodiment, each of the first structure S1 and the second structure S2 may include the second ground connection structure of FIG. 5 or the sixth ground connection structure of FIG. 8. In an embodiment, the third structure S3 may include the fourth ground connection structure of FIG. 7 or the fifth ground connection structure of FIG. 8. In an embodiment, each of the fourth structure S4 and the fifth structure S5 may include the seventh ground connection structure or the eighth ground connection structure of FIG. 8.

In an embodiment, the first structure S1, the second structure S2, and the third structure S3 may be positioned on the first portion 332 of the flexible printed circuit board 330. The first structure S1, the second structure S2, and the third structure S3 may be arranged along a width direction (e.g., an X-axis direction) of the flexible printed circuit board 330. For example, the first structure S1, the second structure S2, and the third structure S3 may be arranged along the X-axis direction in the first portion 332 of the flexible printed circuit board 330. In an embodiment, the first structure S1, the second structure S2, and the third structure S3 may be positioned in order along a direction and may be spaced apart from each other. In an embodiment, the fourth structure S4 and the fifth structure S5 may be positioned to be spaced apart from each other on the first portion 332 of the flexible printed circuit board 330. The fourth structure S4 and the fifth structure S5 may be positioned further away from a second portion 334 of the flexible printed circuit board 330 than the first structure S1, the second structure S2, and the third structure S3. The first to fifth structures S1, S2, S3, S4, and S5 may be positioned to be adjacent to an outside periphery of the first portion 332. However, by the above-described description, arrangement and/or positional relationships of the first to fifth structures S1, S2, S3, S4, and S5 are not limited, and various modifications may be probable.

Referring to FIG. 11, in an embodiment, the support bracket 340 may include a support portion 1141 (e.g., the first part 241 of FIG. 2B) and a sidewall portion 1143 (e.g., the second part 243 of FIG. 2B) surrounding a peripheral of the support portion 1141.

The electronic device 300 according to an embodiment may include a waterproof member 1150 disposed on the support portion 1141. The waterproof member 1150 may include a waterproof adhesive such as a waterproof adhesive liquid or a waterproof tape. The waterproof member 1150 may be formed inside the sidewall portion 1143 along a circumference of the sidewall portion 1143. The waterproof member 1150 may be formed to avoid the flexible printed circuit board 330 or a region in which the first portion 332 of the flexible printed circuit board 330 is positioned on the support bracket 340. For example, the waterproof member 1150 may be disposed on a region of the support bracket 340 around the flexible printed circuit board 330. Accordingly, it may be difficult to implement a ground connection structure for the flexible printed circuit board 330 on the region of the support bracket 340 in which the waterproof member 1150 is disposed. The electronic device 300 according to an embodiment may provide waterproof performance and improved shielding performance while saving an internal space of the electronic device 300 by implementing the first to fifth structures S1, S2, S3, S4, and S5 on the flexible printed circuit board 330.

Referring to Table 1 below, a technical effect in which antenna performance is improved and a deviation in antenna performance is reduced due to the improved shielding performance is described.

Table 1 below shows a reception de-sense in the electronic device 300 and an electronic device according to a comparative example.

**[Table 1]**

| | Reception de-sense [dB] | |
|---|---|---|
| | Electronic device according to comparative example | Electronic device 300 |
| First example | 1.17 | 0.72 |
| Second example | 0.64 | 0.64 |
| Third example | 2.2 | 0.58 |

The de-sense in the Table 1 may indicate degradation in sensitivity of a reception signal through an antenna (e.g., the conductive portion of the second part 243 of FIG. 2B) of an electronic device in a specific frequency band (e.g., a low-band band of 1.0 GHz or less). That is, in the Table 1, it may mean that, as a value of the de-sense increases, a degree to which reception sensitivity is degraded increases. The electronic device 300 according to an embodiment in the Table 1 may include the above-described ground connection structures (e.g., the ground connection structures S1, S2, S3, S4, and S5 of FIG. 11), and the electronic device according to a comparative example may not include the above-described ground connection structures.

Referring to the Table 1, a deviation of the de-sense of the first to third examples of the electronic device 300 according to an embodiment may be decreased compared to a deviation of the first to third examples of the electronic device according to a comparative example. Referring to the first example, the de-sense of the electronic device 300 according to an embodiment may be decreased compared to the de-sense of the electronic device according to a comparative example. Referring to the third example, the de-sense of the electronic device 300 according to an embodiment may be decreased compared to the de-sense of the electronic device according to a comparative example.

FIG. 12 is an exemplary diagram illustrating an electronic device according to an embodiment. Referring to FIG. 12, an electronic device 300 according to an embodiment may include a display 1260 (e.g., the display 360 of FIG. 3). The display 1260 may include a display panel 1262 (e.g., the display panel 362 of FIG. 3). The display panel 1262 may include a substrate 1270 on which a pixel layer configured to emit light is formed. The substrate 1270 may include a first portion 1271 on which the pixel layer is formed, a second portion 1272 positioned between the first portion 1271 and a support bracket 340, and a third portion 1273 extending from the first portion 1271 to the second portion 1272. The substrate 1270 may be formed to be at least partially flexible. For example, the third portion 1273 may be bent from the first portion 1271, and the second portion 1272 extending from the third portion 1273 may be positioned above the first portion 1271 (e.g., in a -Z-axis direction). The substrate 1270 may be referred to as a flexible substrate.

In an embodiment, the second portion 1272 of the substrate 1270 may be understood to include or replace with the second portion 334 of a flexible printed circuit board 1230 described above. In an embodiment, the third portion 1273 of the substrate 1270 may be understood to include or replace with the third portion 336 of the flexible printed circuit board 1230 described above.

The electronic device 300 according to an embodiment may include a printed circuit board 1230. For example, the printed circuit board 1230 may include at least a portion of the flexible printed circuit board 330 (or the first portion 332 of the flexible printed circuit board 330) described above. The printed circuit board 1230 may be positioned between the substrate 1270 and the support bracket 340. For example, the printed circuit board 1230 may be positioned between the first portion 1271 of the substrate 1270 and the support bracket 340. The printed circuit board 1230 may be coupled to the substrate 1270. For example, the printed circuit board 1230 may be coupled to the second portion 1272 of the substrate 1270. A conductive sheet 364 of the display 1260 may be positioned between the printed circuit board 1230 and the first portion 1271 of the substrate 1270.

A DDIC 368 may be disposed on the second portion 1272 of the substrate 1270. The DDIC 368 may be positioned between the second portion 1272 of the substrate 1270 and the support bracket 340. A shielding layer 480 may be disposed on the DDIC 368 and the printed circuit board 1230 (e.g., in the -Z-axis direction). For example, the shielding layer 480 may be disposed on the second portion 1272 of the substrate 1270 and the printed circuit board 1230 to cover the DDIC 368. The DDIC 368 may be electrically connected to the display panel 1262. For example, the DDIC 368 may be electrically connected to the display panel 1262 through an electrical path provided by the substrate 1270.

The electronic device 300 according to an embodiment may further include other integrated circuitry (IC) 1269, which is distinguished from the DDIC 368. The other IC 1269 may include a touch controller IC for driving a sensor for detecting a touch input on a window 302, but is not limited thereto. The other IC 1269 may be disposed on the printed circuit board 1230. The shielding layer 480 may be disposed on the other IC 1269. The shielding layer 480 may be electrically connected to a ground of the printed circuit board 1230 through a second conductive gasket 820, and may be electrically connected to the support bracket 340 through a first conductive gasket 810. EMI with the other IC 1269 may be shielded by the shielding layer 480.

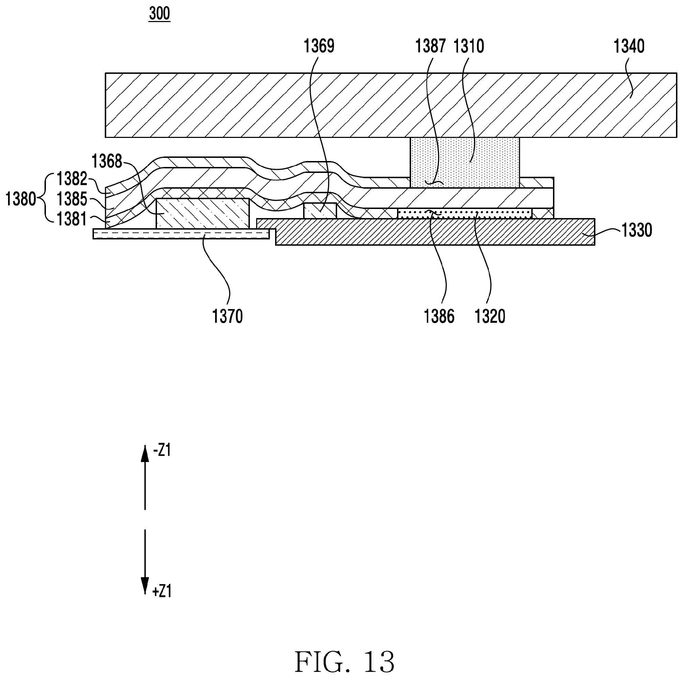

FIG. 13 is an exemplary diagram illustrating an electronic device according to an embodiment. Referring to FIG. 13, an electronic device 300 according to an embodiment may include a conductive member 1340, a shielding member 1380, first IC 1368, a first substrate 1370, a second substrate 1330, a first conductive gasket 1310, and a second conductive gasket 1320.

The conductive member 1340 may include a portion formed of a material having electrical conductivity (e.g., a conductive metal). For example, the conductive member 1340 may include the support bracket 340 or the conductive portion of the support bracket 340 described above, but is not limited thereto.

The first substrate 1370 may include a circuit board, a printed circuit board, a flexible printed circuit, a flexible printed circuit board, or a film circuit board. For example, the first substrate 1370 may include the second portion 334 of the flexible printed circuit board 330 described above, but is not limited thereto. For example, the first substrate 1370 may include the second portion 1272 of the substrate 1270 described above, but is not limited thereto.

The second substrate 1330 may include a circuit board, a printed circuit board, a flexible printed circuit, a flexible printed circuit board, or a film circuit board. For example, the second substrate 1330 may include the first portion 332 of the flexible printed circuit board 330 described above, but is not limited thereto.

The first IC 1368 may be disposed on the first substrate 1370. The electronic device 300 according to an embodiment may further include second IC 1369. The second IC 1369 may be disposed on the second substrate 1330. The first IC 1368 and/or the second IC 1369 may be electrically connected to another component (e.g., the display 1260 of FIG. 12 or the processor 120 of FIG. 1) of the electronic device 300 through the first substrate 1370 and/or the second substrate 1330. The first IC 1368 or the second IC 1369 may include the DDIC 368 or the other IC 1269 described above, but is not limited thereto.

The shielding member 1380 (e.g., a shielding member 480) may be disposed on the first IC 1368 and the second IC 1369. For example, the shielding member 1380 may be disposed on the first substrate 1370 and the second substrate 1330 to cover the first IC 1368 and the second IC 1369. For example, the shielding member 1380 may be attached to the first IC 1368, the second IC 1369, the first substrate 1370, and/or the second substrate 1330.

The shielding member 1380 may include a conductive layer 1385 (e.g., a conductive layer 485) configured to shield EMI with the first IC 1368 and/or the second IC 1369. Additionally, the shielding member 1380 may further include a first non-conductive layer 1381 (e.g., a first non-conductive layer 481) and/or a second non-conductive layer 1382 (e.g., a second non-conductive layer 482) disposed on both surfaces of the conductive layer 1385.

In an embodiment, the first conductive gasket 1310 (e.g., first conductive gaskets 410, 710, or 810) may be disposed between the conductive layer 1385 and the conductive member 1340. In an embodiment, the second conductive gasket 1320 (e.g., second conductive gaskets 420, 720, or 820) may be disposed between the conductive layer 1385 and the second substrate 1330. A partial section of the conductive layer 1385 may be positioned between the first conductive gasket 1310 and the second conductive gasket 1320. For example, the second conductive gasket 1320 may be in contact with the partial section of the conductive layer 1385, and the first conductive gasket 1310 may be at least partially disposed on the partial section of the conductive layer 1385 with which the second conductive gasket 1320 is in contact. The first conductive gasket 1310 may be in contact with the conductive layer 1385 through an opening 1387 (e.g., the opening 887 of FIG. 12) formed in the second non-conductive layer 1382. The second conductive gasket 1320 may be in contact with the conductive layer 1385 through an opening 1386 (e.g., the opening 886 of FIG. 12) formed in the first non-conductive layer 1381.

The second conductive gasket 1320 may electrically connect the conductive layer 1385 to a ground of the second substrate 1330. The first conductive gasket 1310 may stably maintain an electrical connection between the second conductive gasket 1320 and the ground between the second substrate 1330 by providing an elastic force to the second conductive gasket 1320 and the partial section of the conductive layer 1385 with which the second conductive gasket 1320 is in contact. In addition, the first conductive gasket 1310 may electrically connect the conductive layer 1385 to the conductive member 1340. Accordingly, shielding performance for the first IC 1368 and the second IC 1369 may be improved.

An electronic device (e.g., the electronic device 300 of FIG. 3) according to an embodiment may include a support bracket (e.g., the support bracket 340 of FIG. 3), a display (e.g., the display 360 of FIG. 3) supported by the support bracket, a flexible printed circuit board (e.g., the flexible printed circuit board 330 of FIG. 3) electrically connected to the display and disposed between the support bracket and the display to be spaced apart from the support bracket, a DDIC (e.g., the display driving circuitry 368 of FIG. 3) disposed on the flexible printed circuit board and facing the support bracket, a conductive layer (e.g., the conductive layer 485 of FIG. 4) disposed on the flexible printed circuit board to cover the DDIC, a first conductive gasket (e.g., the first conductive gasket 410, 710, or 810) interposed between the conductive layer and the support bracket and electrically connecting the conductive layer and the support bracket, and a second conductive gasket (e.g., the second conductive gasket 420, 720, or 820) interposed between the conductive layer and the flexible printed circuit board, at least partially overlapping the first conductive gasket, and electrically connecting the conductive layer and the flexible printed circuit board. The conductive layer may block noise caused by the DDIC. Through a ground connection structure through the first conductive gasket and the second conductive interface, a shielding effect by the conductive layer may be improved.

In an embodiment, the conductive layer may include a section (e.g., the section 790 of FIG. 7) interposed between the first conductive gasket and the second conductive gasket. The first conductive gasket may be configured to provide an elastic force to the section of the conductive layer with which the second conductive gasket is in contact. Through this, stability of an electrical contact may be improved.

In an embodiment, the conductive layer may include a first surface facing the support bracket and a second surface opposite to the first surface and facing the display. The electronic device may include a first non-conductive layer (e.g., the second non-conductive layer 482 of FIG. 4) disposed on the first surface of the conductive layer and having a first opening (e.g., the first opening 487, 787, or 887) formed therein. The first conductive gasket may be positioned in the first opening of the first non-conductive layer.

In an embodiment, it may include a second non-conductive layer (e.g., a first non-conductive layer 381 of FIG. 4) disposed on the second surface of the conductive layer and having a second opening (e.g., a second opening 386, 786, or 886) formed therein and at least partially overlapping the first opening. The second conductive gasket may be positioned in the second opening of the second non-conductive layer.

In an embodiment, the flexible printed circuit board may include a first surface on which the first conductive gasket is disposed and a second surface opposite to the first surface of the flexible printed circuit board. The display may include a conductive sheet (e.g., the conductive sheet 364 of FIG. 3) facing the second surface of the flexible printed circuit board.

The electronic device may include a third conductive gasket (e.g., a third conductive gasket 430 or 830) interposed between the conductive sheet of the display and the second surface of the flexible printed circuit board and electrically connecting the conductive sheet and the flexible printed circuit board.

In an embodiment, the third conductive gasket may at least partially overlap the second conductive gasket.

In an embodiment, the electronic device may include a fourth conductive gasket (e.g., the fourth conductive gasket 840 of FIG. 8) interposed between the flexible printed circuit board and the support bracket and electrically connecting the flexible printed circuit board and the support bracket. The fourth conductive gasket may be positioned outside the conductive layer.

In an embodiment, the electronic device may include a fifth conductive gasket interposed between the conductive layer and the flexible printed circuit board and spaced apart from the second conductive gasket. The fifth conductive gasket may electrically connect the conductive layer to the flexible printed circuit board.

In an embodiment, the flexible printed circuit board may include a flexible portion (e.g., the second portion 334 of FIG. 3) on which the DDIC is disposed and a rigid portion (e.g., the first portion 332 of FIG. 3) extending from the flexible portion and on which the first conductive gasket and the second conductive gasket are disposed.

In an embodiment, the first conductive gasket may include a urethane fabric nickel gasket.

In an embodiment, the second conductive gasket may include a fabric gasket or a conductive tape.

In an embodiment, a gap (e.g., the gap g of FIG. 4) between the support bracket and the flexible printed circuit board may have a first length. The first conductive gasket may have a second length greater than the first length, and the first length and the second length may be lengths based on a direction substantially perpendicular to the display.

In an embodiment, it may include a window (e.g., the window 302 of FIG. 3) disposed on the display and forming a front surface of the electronic device. The support bracket may support a periphery portion of the window, form a side surface of the electronic device, and include a sidewall (e.g., the sidewall 1141 of FIG. 11) used as an antenna radiator of the electronic device.

An electronic device (e.g., the electronic device 300 of FIG. 3) according to an embodiment may include a support bracket (e.g., the support bracket 340 of FIG. 3) including a conductive portion and a display assembly (e.g., the display 360 of FIG. 3) supported by the support bracket. The display assembly may include a panel (e.g., the display panel 362 of FIG. 3) configured to emit light, a flexible printed circuit board (e.g., the flexible printed circuit board 330 of FIG. 3) extending from the panel and positioned between the panel and the support bracket to be spaced apart from the support bracket, and a DDIC (e.g., the display driving circuitry 368 of FIG. 3) disposed on the flexible printed circuit board and electrically connected to the panel. The electronic device may include a conductive layer (e.g., the conductive layer 485 of FIG. 4) adhered on the flexible printed circuit board to cover the DDIC, a first conductive interface (e.g., a first conductive gasket 410, 710, or 810) disposed between the conductive portion of the support bracket and the conductive layer to be in contact with the conductive portion of the support bracket and the conductive layer, and a second conductive interface (e.g., a second conductive gasket 420, 720, or 820) disposed between the conductive layer and the flexible printed circuit board to be in contact with the conductive layer and a conductive region of the flexible printed circuit board. The first conductive interface may be configured to provide an elastic force to the second conductive interface overlapping the first conductive interface through the conductive layer. The conductive layer may block noise caused by the DDIC. Through a ground connection structure through the first conductive gasket and the second conductive interface, stability of an electrical connection and a shielding effect by the conductive layer may be improved.

In an embodiment, the conductive layer may include a first surface facing the support bracket and a second surface opposite to the first surface and facing the panel. The electronic device may include a first non-conductive layer (e.g., the second non-conductive layer 482 of FIG. 4) disposed on the first surface of the conductive layer and having a first opening (e.g., a first opening 487, 787, or 887) formed therein. The first conductive interface may be positioned in the first opening of the first non-conductive layer.

In an embodiment, the electronic device may include a second non-conductive layer (e.g., the first non-conductive layer 481 of FIG. 4) disposed on the second surface of the conductive layer and having a second opening formed therein and at least partially overlapping the first opening. The second conductive interface may be positioned in the second opening of the second non-conductive layer.

In an embodiment, the flexible printed circuit board may include a first surface and a second surface. The first conductive interface may be disposed on the first surface of the flexible printed circuit board. The display assembly may include a conductive sheet (e.g., the conductive sheet 364 of FIG. 3) facing the second surface of the flexible printed circuit board. The electronic device may include a third conductive interface (e.g., a third conductive gasket 430 or 830) disposed between the conductive sheet and the flexible printed circuit board to be in contact with the conductive sheet of the display assembly and a conductive region of the second surface of the flexible printed circuit board.

In an embodiment, the third conductive interface may at least partially overlap the second conductive interface.

In an embodiment, the electronic device may include a fourth conductive interface (e.g., the fourth conductive gasket 840 of FIG. 8) disposed between the flexible printed circuit board and the support bracket to be in contact with the conductive portion of the support bracket and a conductive region of the flexible printed circuit board, and a fifth conductive interface disposed between the conductive layer and the flexible printed circuit board to be in contact with the conductive layer and a conductive region of the flexible printed circuit board, and spaced apart from the second conductive interface. The fourth conductive interface may be positioned outside the conductive layer.

In an embodiment, the flexible printed circuit board may include a flexible portion (e.g., the second portion 334 of FIG. 3) on which the DDIC is disposed, and a rigid portion (e.g., the first portion 332 of FIG. 3) extending from the flexible portion and on which the first conductive interface and the second conductive interface are disposed.

An electronic device (e.g., the electronic device 300 of FIG. 12) according to an embodiment may include a bracket (e.g., the support bracket 340 of FIG. 12), a display (e.g., the display 1260 of FIG. 12), a shielding member (e.g., the shielding layer 480 of FIG. 12), a first conductive gasket (e.g., the second conductive gasket 820 of FIG. 12), and a second conductive gasket (e.g., the first conductive gasket 810 of FIG. 12). The display may include a display panel (e.g., the display panel 1262 of FIG. 12), display driving integrated circuitry (DDIC) (e.g., the DDIC 368 of FIG. 12), and a flexible printed circuit board (e.g., the flexible printed circuit board 1230 of FIG. 12). The display panel may include a flexible substrate (e.g., the substrate 1270 of FIG. 12) including a portion under the bracket (e.g., the second portion 1272 of FIG. 12). The DDIC may be mounted on the portion of the flexible substrate, positioned between the bracket and the portion of the flexible substrate, and electrically connected to the display panel. The flexible printed circuit board may be disposed between the flexible substrate and the bracket and may be coupled to the portion of the flexible substrate. The shielding member may be disposed on the DDIC and the flexible printed circuit board and may be spaced apart from the bracket. The shielding member may include a conductive layer (e.g., the conductive layer 485 of FIG. 12) configured to shield electromagnetic interference (EMI) from and/or to the DDIC. The first conductive gasket may be disposed between the flexible printed circuit board and the conductive layer, may be in contact with a portion of the conductive layer, and may electrically connect the conductive layer to a ground of the flexible printed circuit board. The second conductive gasket may be disposed between the conductive layer and the bracket, and may be at least partially disposed on the portion of the conductive layer contacted with the first conductive gasket.

In an embodiment, the second conductive gasket may depress the portion of the conductive layer and the first conductive gasket such that the conductive layer is electrically connected to the ground of the flexible printed circuit board through the first conductive gasket.

In an embodiment, the portion of the conductive layer may be interposed between the first conductive gasket and the second conductive gasket. The second conductive gasket may be configured to provide an elastic force to the portion of the conductive layer contacted with the first conductive gasket.

In an embodiment, the shielding member may include a first non-conductive layer (e.g., the first non-conductive layer 481 of FIG. 12) disposed on a first surface of the conductive layer, and a second non-conductive layer (e.g., the second non-conductive layer 482 of FIG. 12) disposed on a second surface of the conductive layer. A first opening (e.g., the opening 886 of FIG. 12) may be formed in the first non-conductive layer. The first conductive gasket may be in contact with the conductive layer through the first opening of the first non-conductive layer. A second opening (e.g., the opening 887 of FIG. 12) may be formed in the second non-conductive layer. The second conductive gasket may be in contact with the conductive layer through the second opening of the second non-conductive layer.

In an embodiment, the display may include a conductive sheet (e.g., the conductive sheet 364 of FIG. 12). The electronic device may include a third conductive gasket (e.g., the third conductive gasket 830 of FIG. 8) disposed between the flexible printed circuit board and the conductive sheet and electrically connecting the conductive sheet to the ground of the flexible printed circuit board.

In an embodiment, the first conductive gasket, the second conductive gasket, and the third conductive gasket may be aligned in a direction substantially perpendicular to the display panel.

In an embodiment, the electronic device may include a fourth conductive gasket (e.g., the fourth conductive gasket 840 of FIG. 8), disposed between the flexible printed circuit board and the bracket, positioned outside the conductive layer, and electrically connecting the ground of the flexible printed circuit board and the bracket.

In an embodiment, the electronic device may include a fifth conductive gasket disposed between the conductive layer and the flexible printed circuit board and spaced apart from the first conductive gasket. The fifth conductive gasket may be in contact with another portion of the conductive layer, and may electrically connect the conductive layer to the ground of the flexible printed circuit board.

In an embodiment, materials and/or sizes of the first conductive gasket and the second conductive gasket may be different.

In an embodiment, a length of the second conductive gasket may be greater than a length of the first conductive gasket. The lengths of the first and second conductive gaskets may be based on a direction substantially perpendicular to the display panel.

In an embodiment, a gap between the bracket and the shielding member may have a first length. The second conductive gasket may have a second length greater than the first length. The first length and the second length may be based on a direction substantially perpendicular to the display panel.

In an embodiment, the first conductive gasket or the second conductive gasket may include a conductive tape, a conductive fabric, a conductive foam, a foam surrounded by a conductive material, or a conductive foam surrounded by a conductive material.

In an embodiment, the bracket may include a conductive part. The second conductive gasket may be disposed between the conductive part of the bracket and the conductive layer, and may electrically connect the conductive layer to the conductive part of the bracket.

In an embodiment, the conductive part of the bracket may be at least partially used as an antenna radiator of the electronic device.

An electronic device (e.g., the electronic device 300 of FIG. 13) according to an embodiment may include a bracket (e.g., the conductive member 1340 of FIG. 13), a printed circuit board (e.g., the second substrate 1330 of FIG. 13), integrated circuitry (IC) (e.g., first IC 1368 of FIG. 13), a shielding member (e.g., the shielding member 1380 of FIG. 13), a first conductive gasket (e.g., the second conductive gasket 1320 of FIG. 13), and a second conductive gasket (e.g., the first conductive gasket 1310 of FIG. 13). The IC may be electrically connected through the printed circuit board to at least another component of the electronic device. The shielding member may be disposed on the IC and the printed circuit board, and may include a conductive layer (e.g., the conductive layer 1385 of FIG. 13) configured to shield electromagnetic interference (EMI) from and/or to the IC. The first conductive gasket may be disposed between the conductive layer and the printed circuit board, may be in contact with a portion of the conductive layer, and may electrically connect the conductive layer to a ground of the printed circuit board. The second conductive gasket may be disposed between the conductive layer and the bracket, at least partially disposed on the portion of the conductive layer contacted with the first conductive gasket.

In an embodiment, the portion of the conductive layer may be interposed between the first conductive gasket and the second conductive gasket. The second conductive gasket may be configured to provide an elastic force to the portion of the conductive layer contacted with the first conductive gasket.

In an embodiment, the electronic device may include a display (e.g., the display 1260 of FIG. 12). The IC may include display driving integrated circuitry (DDIC) (e.g., the DDIC 368 of FIG. 12) electrically connected to the display.

In an embodiment, it may include a window (e.g., the window 302 of FIG. 12), at least partially defining a front surface of the electronic device. The window may include a region attached to the display, and a region attached to the bracket.

In an embodiment, the display may include a display panel (e.g., the display panel 1270 of FIG. 12), a flexible substrate (e.g., the substrate 1270 of FIG. 12), and the DDIC. The flexible substrate may include a first portion (e.g., the first portion 1271 of FIG. 12) on which the display panel is formed and positioned between the display panel and the bracket, a second portion (e.g., the second portion 1272 of FIG. 12) positioned between the first portion and the bracket, and a bending portion (e.g., the bending portion 1273 of FIG. 12) extending from the first portion to the second portion. The DDIC may be formed on the second portion of the flexible substrate, and may be positioned between the second portion of the flexible substrate and the bracket. The printed circuit board may be coupled to the second portion of the flexible substrate.

In an embodiment, the printed circuit board may include a flexible portion and a rigid portion. The IC may be disposed on the flexible portion of the printed circuit board. The first conductive gasket may be disposed on the rigid portion of the printed circuit board.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a bracket;
a printed circuit board (PCB);
integrated circuitry (IC), electrically connected through the PCB to at least another component of the electronic device;
a shielding member, disposed on the IC and the PCB, and including a conductive layer configured to shield electromagnetic interference from and/or to the IC;
a first conductive gasket, disposed between the conductive layer and the PCB, contacted with a portion of the conductive layer, and electrically connecting the conductive layer to a ground of the PCB; and
a second conductive gasket, disposed between the conductive layer and the bracket, at least partially disposed on the portion of the conductive layer contacted with the first conductive gasket.

2. The electronic device of claim 1 comprising:
a display,
wherein the IC includes display driving integrated circuitry (DDIC) electrically connected to the display.

3. The electronic device of claim 2, comprising a window, at least partially defining a front surface of the electronic device, the window including:
a region attached to the display; and
another region attached to the bracket.

4. The electronic device of claim 2 or claim 3,
wherein the display includes:
a display panel;
a flexible substrate including:
a first portion on which the display panel is formed, positioned between the display panel and the bracket;
a second portion positioned between the first portion and the bracket; and
a bending portion extending from the first portion to the second portion; and
the DDIC, formed on the second portion of the flexible substrate, positioned between the second portion of the flexible substrate and the bracket, and
wherein the PCB is coupled to the second portion of the flexible substrate.

5. The electronic device of claim 4, wherein:
the display includes a conductive sheet disposed between the PCB and the first portion of the flexible substrate; and
the electronic device comprises a third conductive gasket disposed between the PCB and the conductive sheet and electrically connecting the conductive sheet to the ground of the PCB.

6. The electronic device of claim 5,
wherein the first conductive gasket, the second conductive gasket, and the third conductive gasket are aligned in a direction substantially perpendicular to the display panel.

7. The electronic device of any one of claims 1 to 6,
wherein the second conductive gasket depresses the portion of the conductive layer and the first conductive gasket such that the conductive layer is electrically connected to the ground of the PCB through the first conductive gasket.

8. The electronic device of any one of claims 1 to 7, wherein:
the portion of the conductive layer is interposed between the first conductive gasket and the second conductive gasket; and
the second conductive gasket is configured to provide an elastic force to the portion of the conductive layer contacted with the first conductive gasket.

9. The electronic device of any one of claims 1 to 8, wherein:
the shielding member includes a first non-conductive layer disposed on a first surface of the conductive layer, and a second non-conductive layer disposed on a second surface of the conductive layer;
a first opening is formed in the first non-conductive layer;
the first conductive gasket is in contact with the conductive layer through the first opening of the first non-conductive layer;
a second opening is formed in the second non-conductive layer; and
the second conductive gasket is in contact with the conductive layer through the second opening of the second non-conductive layer.

10. The electronic device of any one of claims 1 to 9,
wherein materials and/or sizes of the first conductive gasket and the second conductive gasket are different.

11. The electronic device of any one of claims 1 to 10,
wherein a length of the second conductive gasket is greater than a length of the first conductive gasket, and
the lengths of the first and second conductive gaskets are based on a direction substantially perpendicular to the bracket.

12. The electronic device of any one of claims 1 to 11, wherein:
a gap between the bracket and the shielding member has a first length;
the second conductive gasket has a second length greater than the first length; and
the first length and the second length are based on a direction substantially perpendicular to the bracket.

13. The electronic device of any one of claims 1 to 12,
wherein the first conductive gasket or the second conductive gasket includes:
a conductive tape;
a conductive fabric;
a conductive foam;
a foam surrounded by a conductive material; or
a conductive foam surrounded by a conductive material.

14. The electronic device of any one of claims 1 to 13, wherein:
the bracket includes a conductive part; and
the second conductive gasket is disposed between the conductive part of the bracket and the conductive layer, and electrically connects the conductive layer to the conductive part of the bracket.

15. The electronic device of any one of claims 1 to 7, comprising:
a fourth conductive gasket, disposed between the PCB and the bracket, positioned outside the conductive layer, and electrically connecting the ground of the PCB and the bracket; or
a fifth conductive gasket disposed between the conductive layer and the PCB and spaced apart from the first conductive gasket, and wherein the fifth conductive gasket is in contact with another portion of the conductive layer and electrically connects the conductive layer to the ground of the PCB.
